(19) Europäisches Patentamt
European Patent Office
Office européen des brevets

(11) EP 1 850 650 A1

(12) **EUROPEAN PATENT APPLICATION**

(43) Date of publication:
**31.10.2007 Bulletin 2007/44**

(51) Int Cl.:
*H05K 9/00* *(2006.01)*    *H01Q 17/00* *(2006.01)*

(21) Application number: **07008575.8**

(22) Date of filing: **26.04.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **27.04.2006 JP 2006123368**

(71) Applicant: **NITTO DENKO CORPORATION Osaka (JP)**

(72) Inventor: **Niino, Takuya Ibaraki-shi, Osaka (JP)**

(74) Representative: **Grünecker, Kinkeldey, Stockmair & Schwanhäusser Anwaltssozietät Maximilianstrasse 58 80538 München (DE)**

(54) **Structure having a characteristic of conducting or absorbing electromagnetic waves**

(57)     The present invention relates to a structure having a characteristic of conducting or absorbing electromagnetic waves, which comprises a substrate; and a fiber convex structure section which has a characteristic of conducting or absorbing electromagnetic waves and is formed at least partially on the substrate in such a form that at least a part of a fiber thereof is positioned outward from the surface of the substrate, in which the surfaces on each of which the fiber convex structure sections having a characteristic of conducting or absorbing electromagnetic waves is formed are superposed with each other in an opposed state. The structure of the present invention, even in the case that the fiber convex structure section having a characteristic of conducting or absorbing electromagnetic waves is provided, can effectively hold the fibers and is capable of suppressing or preventing coming-out of the fibers, thereby exhibiting the characteristic of conducting or absorbing electromagnetic waves at an excellent level.

FIG. 2

## Description

FIELD OF THE INVENTION

The present invention relates to a structure having a characteristic of conducting or absorbing electromagnetic waves.

BACKGROUND OF THE INVENTION

In various kinds of joining (especially, joining of electronic parts) for which a pressure-sensitive adhesive tape is used, it has been frequently required to have a characteristic of conducting or absorbing electromagnetic waves such as an electrical conductivity and electromagnetic shielding properties. For that reason, with respect to a method for providing (realizing) a characteristic of conducting or absorbing electromagnetic waves such as electrical conductivity and electromagnetic shielding properties in a pressure-sensitive adhesive tape, there have hitherto been made a lot of investigations. For example, as materials having electrical conductivity or electromagnetic shielding properties, there are proposed an electrically conductive mutual connecting material obtained by a non-random single layer coating of a particle (see Patent Reference 1); an electrically conductive sealing material obtained by blending a silica powder, carbon black and a metal powder in a silicone rubber (see Patent Reference 2); and so on. As materials having electrical conductivity or electromagnetic shielding properties, there is also proposed a high molecular molded member having electromagnetic shielding properties in which flocks formed by electrically conductive fibers are flocked on a high molecular substrate and electrical conductivity is imparted between flocks at the roots of the flocks (see Patent Reference 3).

For the purpose of keeping electrical conductivity, it is required in the foregoing electrically conductive mutual connecting material that particles having electrical conductivity be regularly aligned. Such regular alignment of the particles, if possible, is certainly useful in view of the electrical conductivity, but such regular alignment of the particles is very complicated and is accompanied by difficulty in the process steps.

Furthermore, the foregoing electrically conductive sealing material is provided with an electrical conductivity by kneading particles having electrical conductivity into a resin of various kinds. For that reason, the preparation method in this case is simple, and there is less problems in view of process steps. However, in order to impart electrical conductivity, a large amount of the electrically conductive particles must be blended, and as a result, there was involved a defect that the costs become comparatively high. Moreover, since a large amount of the electrically conductive particles is blended, there is also involved a defect that other characteristics are affected.

In addition, since the foregoing high molecular molded member having electromagnetic shielding properties has a construction in which electrically conductive fibers are flocked on a high molecular substrate by using an adhesive layer having electrical conductivity, etc., the electromagnetic shielding properties are improved, but it cannot be said that such an improvement is sufficient. Thus, a structure having even better electromagnetic shielding properties is demanded. Moreover, since the electrically conductive fibers are merely flocked in the adhesive layer having electrical conductivity, they are liable to come out. The electrically conductive fiber which has come out from the adhesive layer having electrical conductivity becomes a dust or adversely affects a device into which the high molecular molded member having electromagnetic shielding properties is installed or surrounding instruments thereof. Thus, in the case of using an electrically conductive fiber, good retention of the electrically conductive fiber is demanded.

Patent Reference 1: JP-T-2002-501821
Patent Reference 2: JP-A-10-120904
Patent Reference 3: JP-A-61-2394

## SUMMARY OF THE INVENTION

Accordingly, an object of the present invention is to provide a structure which, even in the presence of a fiber convex structure section having a characteristic of conducting or absorbing electromagnetic waves, effectively holds the fibers and is capable of suppressing or preventing coming-out of the fibers, thereby exhibiting the characteristic of conducting or absorbing electromagnetic waves at an excellent level.

Another object of the invention is to provide a structure which can be advantageously applied as an electrically conductive material, an electromagnetic wave absorbing material or an electromagnetic shielding material.

In order to achieve the foregoing objects, the present inventors made extensive and intensive investigations. As a result, it has been found that, by superposing structures each having a specific structure section in which fibers having electrical conductivity are formed on a pressure-sensitive adhesive layer with each other, it is rendered possible to effectively hold the fibers thereby suppressing or preventing coming-out of the fibers and also to exhibit a characteristic of conducting or absorbing electromagnetic waves at an excellent level. The invention has been accomplished on the basis of these findings.

BRIEF DESCRIPTION OF THE DRAWINGS

Figs. 1A and 1B are partial schematic cross-sectional views illustrating examples of a structure of the present invention.

Fig. 2 is a partial schematic cross-sectional view illustrating an example of the structure of the present invention.

Figs. 3A and 3B are partial schematic cross-sectional views illustrating examples of the structure of the present invention.

Fig. 4 is a partial schematic cross-sectional view illustrating another example of the structure of the present invention.

Figs. 5A to 5C are schematic cross-sectional views illustrating examples of a structure-constituting member of the present invention.

Fig. 6 is a partial schematic cross-sectional view illustrating another example of the structure of the present invention.

Figs. 7A and 7B are schematic views illustrating shield boxes to be used in a KEC method electromagnetic shield evaluation system, and respectively illustrate an electric field shield box and a magnetic field shield box.

Description of Symbols

| | |
|---|---|
| 1: | structure |
| 11: | structure-constituting member |
| 11a: | substrate |
| 11b: | surface of substrate 11a |
| 11c: | electromagnetic conducting or absorbing fiber convex structure section |
| 12: | structure-constituting member |
| 12a: | substrate |
| 12b: | surface of substrate 12a |
| 12c: | electromagnetic conducting or absorbing fiber convex structure section |
| 2: | structure |
| 21: | structure-constituting member |
| 21a: | substrate |
| 21b: | surface of substrate 21a |
| 21c: | electromagnetic conducting or absorbing fiber convex structure section |
| 22: | structure-constituting member |
| 22a: | substrate |
| 22b: | surface of substrate 22a |
| 22c: | electromagnetic conducting or absorbing fiber convex structure section |
| 3: | structure |
| 31: | structure-constituting member |
| 31a: | substrate |
| 31b: | surface of substrate 31a |
| 31c: | electromagnetic conducting or absorbing fiber convex structure section |
| 32: | structure-constituting member |
| 32a: | substrate |
| 32b: | surface of substrate 32a |
| 32c: | electromagnetic conducting or absorbing fiber convex structure section |
| 33: | structure-constituting member |
| 33a: | substrate |
| 33b: | surface of substrate 33a |
| 33c: | electromagnetic conducting or absorbing fiber convex structure section |
| 4: | structure |
| 41: | structure-constituting member |
| 41a: | substrate |
| 41b: | surface of substrate 41a |
| 41c: | electromagnetic conducting or absorbing fiber convex structure section |
| 5: | structure |
| 51: | structure-constituting member |

51a:   substrate
51b:   surface of substrate 51a
51c:   electromagnetic conducting or absorbing fiber convex structure section
6:   structure
61:   structure-constituting member
61a:   substrate
61b:   electromagnetic conducting or absorbing fiber convex structure section
61c:   electromagnetic conducting or absorbing fiber convex structure section
62:   structure-constituting member
62a:   substrate
62b:   electromagnetic conducting or absorbing fiber convex structure section
63:   structure-constituting member
63a:   substrate
63b:   electromagnetic conducting or absorbing fiber convex structure section
7a:   structure-constituting member
7a1:   pressure-sensitive adhesive or adhesive layer (pressure-sensitive adhesive layer or adhesive layer)
7a2:   substrate
7a3:   electromagnetic conducting or absorbing fiber-napped section
7b:   structure-constituting member
7b 1:   pressure-sensitive adhesive layer
7b2:   release liner
7b3:   electromagnetic conducting or absorbing fiber-napped section
7c:   structure-constituting member
7c1:   polymer layer
7c2:   electromagnetic conducting or absorbing fiber-napped section
8:   structure
81:   structure-constituting member
81a:   substrate
81b:   electromagnetic conducting or absorbing fiber convex structure section
81c:   electromagnetic conducting or absorbing fiber convex structure section
81d:   coating layer
82:   structure-constituting member
82a:   substrate
82b:   electromagnetic conducting or absorbing fiber convex structure section

DETAILED DESCRIPTION OF THE INVENTION

Namely, the present invention relates to the followings.

(1) A structure having a characteristic of conducting or absorbing electromagnetic waves, which comprises:

a substrate; and
a fiber convex structure section having a characteristic of conducting or absorbing electromagnetic waves, which is formed at least partially on the substrate in such a form that at least a part of a fiber thereof is positioned outward from the surface of the substrate,

wherein the surfaces on each of which the fiber convex structure sections having a characteristic of conducting or absorbing electromagnetic waves is formed are superposed with each other in an opposed state.
(2) The structure according to (1), which comprises one or a plurality of members each having a substrate and a fiber convex structure section which has a characteristic of conducting or absorbing electromagnetic waves and is formed at least partially on the substrate in such a form that at least a part of a fiber thereof is positioned outward from the surface of the substrate,
wherein said one or plurality of members are folded and/or laminated so that the surfaces on each of which the fiber convex structure sections having a characteristic of conducting or absorbing electromagnetic waves is formed are superposed with each other in an opposed state.
(3) The structure according to (2), wherein, on each of the surfaces opposed with each other when said one or plurality of members are superposed, the fiber convex structure section having a characteristic of conducting or absorbing electromagnetic waves is partially formed in such a form that a portion of one surface on which the fiber convex structure section having a characteristic of conducting or absorbing electromagnetic waves is formed is capable of being superposed in an opposed state with a portion of another surface on which the fiber convex structure section having a characteristic of conducting or absorbing electromagnetic waves is not formed.

(4) The structure according to (3), wherein the fiber convex structure section having a characteristic of conducting or absorbing electromagnetic waves is formed partially on the substrate, by superposing a member having a hole section on the surface of the substrate, forming the fiber convex structure section having a characteristic of conducting or absorbing electromagnetic waves on a portion of the surface of the substrate corresponding to the hole section of the member having a hole section, and then peeling off the member having a hole section.

(5) The structure according to (2), wherein, on each of the surfaces opposed with each other when said one or plurality of members are superposed, the fiber convex structure section having a characteristic of conducting or absorbing electromagnetic waves is entirely formed in such a form that a fiber of the fiber convex structure section having a characteristic of conducting or absorbing electromagnetic waves on one surface is positioned between fibers of the fiber convex structure section having a characteristic of conducting or absorbing electromagnetic waves on another surface so that the surfaces are capable of being superposed with each other.

(6) The structure according to any one of (1) to (5), wherein the substrate is at least one member selected from the group consisting of a pressure-sensitive adhesive layer, an adhesive layer and a polymer layer.

(7) The structure according to any one of (1) to (6), wherein the substrate has a characteristic of conducting or absorbing electromagnetic waves.

(8) The structure according to any one of (1) to (7), wherein the substrate is formed on at least one surface of a support.

(9) The structure according to (8), wherein the support has a characteristic of conducting or absorbing electromagnetic waves.

(10) The structure according to any one of (1) to (9), which is a sheet-like structure having a sheet-like form.

(11) The structure according to any one of (1) to (10), which is used as an electrically conductive material.

(12) The structure according to any one of (1) to (10), which is used as an electromagnetic wave absorbing material.

(13) The structure according to any one of (1) to (10), which is used as an electromagnetic wave shielding material.

The structure of the present invention preferably has such a construction that one or a plurality of members (structure-constituting members), in each of which a fiber convex structure section having a characteristic of conducting or absorbing electromagnetic waves is formed at least partially on a substrate in such a form that at least a part of a fiber thereof is positioned outward from the surface of the substrate, are folded and/or laminated so that surfaces on each of which the fiber convex structure sections having a characteristic of conducting or absorbing electromagnetic waves is formed are superposed with each other in an opposed state.

Further, the structure of the present invention may have such a construction that, on each of the surfaces opposed with each other when one or a plurality of structure-constituting members are superposed, the fiber convex structure section having a characteristic of conducting or absorbing electromagnetic waves is partially formed in such a form that a portion of one surface on which the fiber convex structure section having a characteristic of conducting or absorbing electromagnetic waves is formed can be superposed in an opposed state with a portion of another surface on which the fiber convex structure section having a characteristic of conducting or absorbing electromagnetic waves is not formed. In this case, the fiber convex structure section having a characteristic of conducting or absorbing electromagnetic waves is formed partially on the substrate, preferably by superposing a member having a hole section on the surface of the substrate, forming a fiber convex structure section having a characteristic of conducting or absorbing electromagnetic waves on a portion of the surface of the substrate corresponding to the hole section of the member having a hole section, and then peeling off the member having a hole section.

Further, the structure of the present invention may have such a construction that, on each of the surfaces opposed with each other when one or a plurality of structure-constituting members are superposed, the fiber convex structure section having a characteristic of conducting or absorbing electromagnetic waves is entirely formed in such a form that a fiber of the fiber convex structure section having a characteristic of conducting or absorbing electromagnetic waves on one surface is positioned between fibers of the fiber convex structure section having a characteristic of conducting or absorbing electromagnetic waves on another surface so that the surfaces can be superposed with each other.

In the foregoing structure, the substrate is advantageously at least one layer selected from the group consisting of a pressure-sensitive adhesive layer, an adhesive layer, and a polymer layer. The substrate preferably has a characteristic of conducting or absorbing electromagnetic waves. The substrate may be formed on at least one surface of a support, and such support preferably has a characteristic of conducting or absorbing electromagnetic waves.

As such structure, a sheet-like structure having a sheet-like form is suitable.

The structure of the present invention can be advantageously used as an electrically conductive material, an electromagnetic wave absorbing material or an electromagnetic shielding material.

The structure of the present invention, having the aforementioned construction, even in the case that the fiber convex structure section having a characteristic of conducting or absorbing electromagnetic waves is provided, can effectively hold the fibers and is capable of suppressing or preventing coming-out of the fibers, thereby exhibiting the characteristic of conducting or absorbing electromagnetic waves at an excellent level. Therefore, the structure of the present invention can be advantageously used as an electrically conductive material, an electromagnetic wave absorbing material or an electromagnetic shielding material.

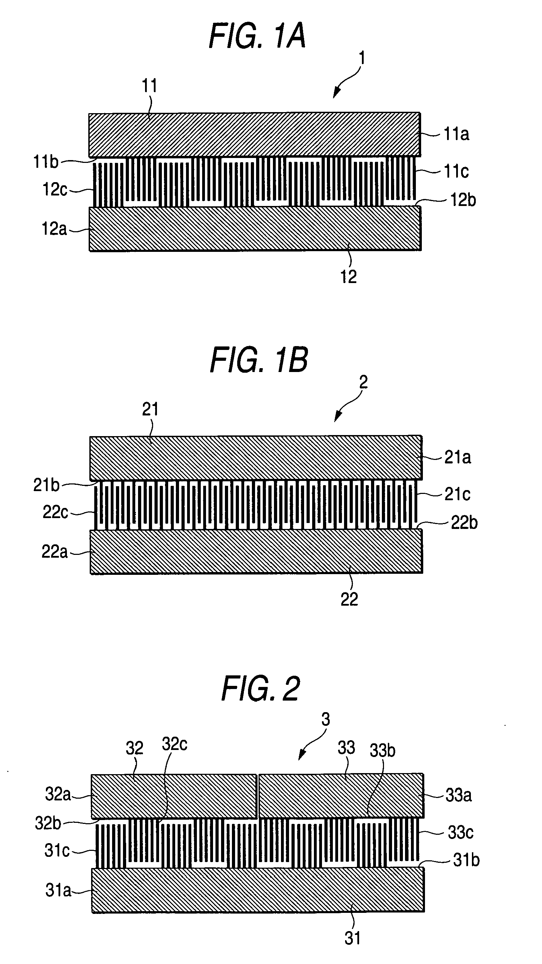

The structure of the present invention is a structure, as illustrated in Figs 1A to 3B, having such a construction that a fiber convex structure section having a characteristic of conducting or absorbing electromagnetic waves (the fiber convex structure section being hereinafter also called "electromagnetic conducting or absorbing fiber convex structure section") is formed at least partially on a substrate in a form that at least a part of a fiber thereof is positioned outward from the surface of the substrate, thereby exhibiting a characteristic of conducting or absorbing electromagnetic waves, and such a construction that the surfaces on each of which the fiber convex structure sections having a characteristic of conducting or absorbing electromagnetic waves is formed are superposed with each other in an opposed state. Accordingly, since the structure of the invention has the electromagnetic conducting or absorbing fiber convex structure section, it can exhibit a characteristic of conducting or absorbing electromagnetic waves (hereinafter also called "electromagnetic conducting or absorbing properties") at an excellent level. Besides, even in the case that the electromagnetic conducting or absorbing fiber convex structure sections are provided, the surfaces on each of which the fiber convex structure sections having a characteristic of conducting or absorbing electromagnetic waves is formed are superposed with each other in an opposed state, thereby effectively holding the fibers and being capable of suppressing or preventing coming-out of the fibers.

Furthermore, according to the structure of the invention, in superposing the surfaces on each of which the fiber convex structure sections having a characteristic of conducting or absorbing electromagnetic waves is formed with each other in an opposed state, a tumbling of the fiber in the electromagnetic conducting or absorbing fiber convex structure section can be suppressed or prevented by executing the superposing in such a form that the fibers of the electromagnetic conducting or absorbing fiber convex structure sections are complexly entangled.

Figs. 1A to 3B are schematic partial cross-sectional views illustrating examples of the structure of the invention. Referring to Fig. 1A, there are illustrated a structure 1, a structure-constituting member 11, a substrate 11a, a surface 11b of the substrate 11a, an electromagnetic conducting or absorbing fiber convex structure section 11c, a structure-constituting member 12, a substrate 12a, a surface 12b of the substrate 12a, and an electromagnetic conducting or absorbing fiber convex structure section 12c. The structure 1 illustrated in Fig. 1A has a construction, in which a structure-constituting member 11, having the electromagnetic conducting or absorbing fiber convex structure section 11c partially on the surface 11b of the substrate 11a, and a structure-constituting member 12, having the electromagnetic conducting or absorbing fiber convex structure section 12c partially on the surface 12b of the substrate 12a, are laminated whereby the structure-constituting member 11 and the structure-constituting member 12 are superposed in such a form that the surfaces (11b, 12b) on each of which the electromagnetic conducting or absorbing fiber convex structure sections is formed are opposed with each other. As will be apparent from Fig. 1A, the electromagnetic conducting or absorbing fiber convex structure section 11c is formed in such a form that at least a part of a fiber thereof is positioned outward from the surface 11b of the substrate 11a, and the electromagnetic conducting or absorbing fiber convex structure section 12c is formed in such a form that at least a part of a fiber thereof is positioned outward from the surface 12b of the substrate 12a.

Referring to Fig. 1B, there are illustrated a structure 2, a structure-constituting member 21, a substrate 21a, a surface 21b of the substrate 21a, an electromagnetic conducting or absorbing fiber convex structure section 21c, a structure-constituting member 22, a substrate 22a, a surface 22b of the substrate 22a, and an electromagnetic conducting or absorbing fiber convex structure section 22c. The structure 2 illustrated in Fig. 1B has a construction, in which a structure-constituting member 21, having the electromagnetic conducting or absorbing fiber convex structure section 21c entirely over the surface 21b of the substrate 21a, and a structure-constituting member 22, having the electromagnetic conducting or absorbing fiber convex structure section 22c entirely over the surface 22b of the substrate 22a, are laminated whereby the structure-constituting member 21 and the structure-constituting member 22 are superposed in such a form that the surfaces (21b, 22b) on each of which the electromagnetic conducting or absorbing fiber convex structure sections is formed are opposed with each other. As will be apparent from Fig. 1B, the electromagnetic conducting or absorbing fiber convex structure section 21c is formed in such a form that at least a part of a fiber thereof is positioned outward from the surface 21b of the substrate 21a, and the electromagnetic conducting or absorbing fiber convex structure section 22c is formed in such a form that at least a part of a fiber thereof is positioned outward from the surface 22b of the substrate 22a.

Referring to Fig. 2, there are illustrated a structure 3, a structure-constituting member 31, a substrate 31a, a surface 31b of the substrate 31a, an electromagnetic conducting or absorbing fiber convex structure section 31c, a structure-constituting member 32, a substrate 32a, a surface 32b of the substrate 32a, an electromagnetic conducting or absorbing fiber convex structure section 32c, a structure-constituting member 33, a substrate 33a, a surface 33b of the substrate 33a, and an electromagnetic conducting or absorbing fiber convex structure section 33c. The structure 3 illustrated in Fig. 2 has a construction in which, on one end side of the structure-constituting member 31, having the electromagnetic conducting or absorbing fiber convex structure section 31c partially on the surface 31b of the substrate 31a, the structure-constituting member 32, having the electromagnetic conducting or absorbing fiber convex structure section 32c partially on the surface 32b of the substrate 32a, is laminated whereby the structure-constituting member 31 and the structure-constituting member 32 are superposed in such a form that the surfaces (31b, 32b) on each of which the electromagnetic conducting or absorbing fiber convex structure sections is formed are opposed with each other, and on the other end side of the structure-constituting member 31, the structure-constituting member 33, having the electromagnetic conducting or absorbing fiber convex structure section 33c partially on the surface 33b of the substrate 33a, is laminated whereby the structure-constituting member 31 and the structure-constituting member 33 are superposed in such a form that the surfaces (31b, 33b) on each of which the electromagnetic conducting or absorbing fiber convex structure sections is formed are opposed with each other. As will be apparent from Fig. 2, the electromagnetic conducting or absorbing fiber convex structure section 31c is formed in such a form that at least a part of a fiber thereof is positioned outward from the surface 31b of the substrate 31a, the electromagnetic conducting or absorbing fiber convex structure section 32c is formed in such a form that at least a part of a fiber thereof is positioned outward from the surface 32b of the substrate 32a, and the electromagnetic conducting or absorbing fiber convex structure section 33c is formed in such a form that at least a part of a fiber thereof is positioned outward from the surface 33b of the substrate 33a.

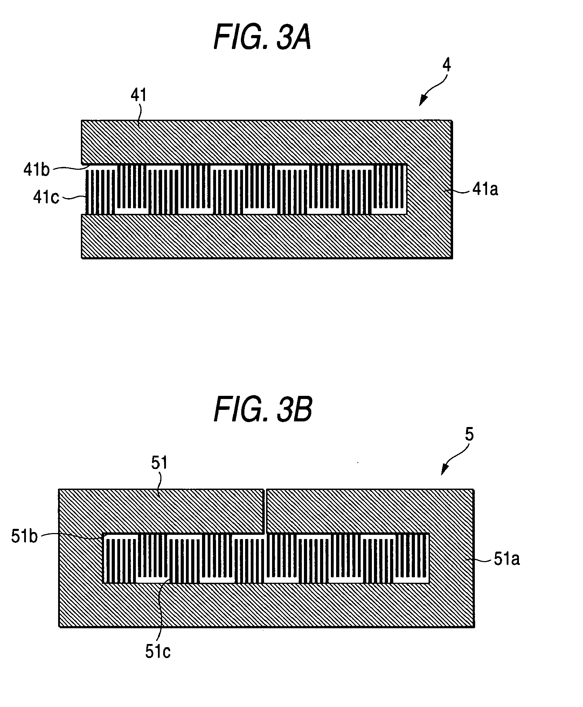

Further referring to Fig. 3A, there are illustrated a structure 4, a structure-constituting member 41, a substrate 41a, a surface 41b of the substrate 41a, and an electromagnetic conducting or absorbing fiber convex structure section 41c. The structure 4 illustrated in Fig. 3A has a construction in which the structure-constituting member 41, having the electromagnetic conducting or absorbing fiber convex structure section 41c partially on the surface 41b of the substrate 41a is folded, at the center of a shorter direction, along a longitudinal direction in such a form that an end portion is positioned on the other end portion, whereby the structure-constituting member 41 is superposed in such a form that the surface 41b on which the electromagnetic conducting or absorbing fiber convex structure section is formed is laminated in itself in mutually opposed manner. As will be apparent from Fig. 3A, the electromagnetic conducting or absorbing fiber convex structure section 41c is formed in such a form that at least a part of a fiber thereof is positioned outward from the surface 41 b of the substrate 41 a.

Further referring to Fig. 3B, there are illustrated a structure 5, a structure-constituting member 51, a substrate 51a, a surface 51b of the substrate 51a, and an electromagnetic conducting or absorbing fiber convex structure section 51c. The structure 5 illustrated in Fig. 3B has a construction in which the structure-constituting member 51, having the electromagnetic conducting or absorbing fiber convex structure section 5 1c partially on the surface 51b of the substrate 51a is folded, at the centers between end portions and center of a shorter direction, along a longitudinal direction in such a form that end portions are positioned on the center, whereby the structure-constituting member 51 is superposed in such a form that the surface 51b on which the electromagnetic conducting or absorbing fiber convex structure section is formed is laminated in itself in mutually opposed manner. As will be apparent from Fig. 3B, the electromagnetic conducting or absorbing fiber convex structure section 51c is formed in such a form that at least a part of a fiber thereof is positioned outward from the surface 51b of the substrate 51a.

The structure-constituting members illustrated in Figs. 1A to 3B have a sheet-like form. Particularly, in the structure illustrated in Figs. 3A and 3B, it is important that the structure-constituting member has a flexibility as the structure-constituting member is folded.

Also the structures in Figs. 1A to 2 have a construction formed by laminating plural structure-constituting members, while the structures in Figs. 3A and 3B have a construction formed by folding a single structure-constituting member, but the structure of the invention may naturally have a construction formed by a combination of a folding of any one structure-constituting member and of a lamination of plural structure-constituting members.

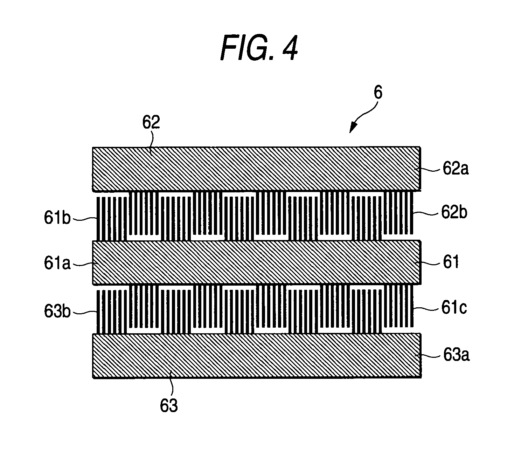

Also in case of utilizing a structure-constituting member having electromagnetic conducting or absorbing fiber convex structure sections on both sides of a substrate, the structure of the invention may be formed, as illustrated in Fig. 4, by employing structure-constituting members each having the electromagnetic conducting or absorbing fiber convex structure section on one side only of a substrate as structure-constituting members of outermost layers and by laminating the plural structure-constituting members in such a form that the surfaces on which the electromagnetic conducting or absorbing fiber convex structure sections is formed are opposed with each other.

Fig. 4 is a schematic partial cross-sectional view illustrating another example of the structure of the invention. Referring to Fig. 4, there are illustrated a structure 6, a structure-constituting member 61, a substrate 61a, an electromagnetic conducting or absorbing fiber convex structure section 6 1 b, an electromagnetic conducting or absorbing fiber convex structure section 61c, a structure-constituting member 62, a substrate 62a, an electromagnetic conducting or absorbing fiber convex structure section 62b, a structure-constituting member 63, a substrate 63a, and an electromagnetic conducting or absorbing fiber convex structure section 63b. In Fig. 4, the structure-constituting member 61 has a construction having electromagnetic conducting or absorbing fiber convex structure sections (61b, 61c) partially on the respective surfaces of the substrate 61a, while the structure-constituting member 62 has a construction having electromagnetic conducting or absorbing fiber convex structure section 62b partially on a surface of the substrate 62a, and the structure-constituting member 63 has a construction having electromagnetic conducting or absorbing fiber convex structure sections 63b partially on a surface of the substrate 63a. The structure 6 illustrated in Fig. 4 has a construction that the structure-constituting member 61 and the structure-constituting member 62 are superposed in such a form that a surface of the structure-constituting member 61 on which the electromagnetic conducting or absorbing fiber convex structure section 61b is formed and a surface of the structure-constituting member 62 on which the electromagnetic conducting or absorbing fiber convex structure section 62b is formed are opposed with each other, and a construction that the structure-constituting member 61 and the structure-constituting member 63 are superposed in such a form that a surface of the structure-constituting member 61 on which the electromagnetic conducting or absorbing fiber convex structure section 61c is formed and a surface of the structure-constituting member 63 on which the electromagnetic conducting or absorbing fiber convex structure section 63b is formed are opposed with each other. As will be apparent from Fig. 4, each of the electromagnetic conducting or absorbing fiber convex structure sections (61b, 61c, 62b, 63b) in the structure-constituting members 61 to 63 is in such a form that at least a part of a fiber thereof is positioned outward from the surface of the substrate.

Fig. 4 illustrates a case of employing a single structure-constituting member having electromagnetic conducting or absorbing fiber convex structure sections on both surfaces of a substrate, but in case of employing plural structure-constituting members each having electromagnetic conducting or absorbing fiber convex structure sections on both surfaces of a substrate, a structure of the invention can be prepared by employing structure-constituting members each having the electromagnetic conducting or absorbing fiber convex structure section on one side only of a substrate as structure-constituting members of outermost layers and by laminating the plural structure-constituting members in such a form that the surfaces on each of which the electromagnetic conducting or absorbing fiber convex structure sections is formed are opposed with each other.

As the structure of the invention has a construction that the surfaces on each of which the electromagnetic conducting or absorbing fiber convex structure sections is formed are superposed with each other in an opposed manner, the electromagnetic conducting or absorbing fiber convex structure section is preferably formed on each surface in such a form that the superposition can be realized without tumbling the fibers in the electromagnetic conducting or absorbing fiber convex structure sections formed on the opposed surfaces, thereby effectively exhibiting the electromagnetic conducting or absorbing properties. More specifically, in the case of employing a structure-constituting member having a construction in which the electromagnetic conducting or absorbing fiber convex structure section is partially formed on the substrate, on each of the surfaces opposed with each other when one or a plurality of structure-constituting members are superposed, the electromagnetic conducting or absorbing fiber convex structure section is formed partially in such a construction that a portion on one surface in which the electromagnetic conducting or absorbing fiber convex structure section is formed is opposed to and can be superposed with a portion on the other surface in which the electromagnetic conducting or absorbing fiber convex structure section is not formed.

In the case of employing a structure-constituting member having a construction in which the electromagnetic conducting or absorbing fiber convex structure section is partially formed on the substrate, the electromagnetic conducting or absorbing fiber convex structure section can be formed partially on a prescribed portion of the substrate, in such a form that a portion of one surface on which the electromagnetic conducting or absorbing fiber convex structure section is formed can be superposed in an opposed state with a portion of another surface on which the electromagnetic conducting or absorbing fiber convex structure section is not formed, for example, by superposing a member having a hole section on the surface of the substrate, and forming an electromagnetic conducting or absorbing fiber convex structure section on a portion of the surface of the substrate corresponding to the hole section of the member having a hole section.

Also in the case of employing a structure-constituting member having a construction in which the electromagnetic conducting or absorbing fiber convex structure section is formed entirely over the surface of the substrate, on each of the surfaces opposed with each other when one or a plurality of structure-constituting members are superposed, the electromagnetic conducting or absorbing fiber convex structure section is preferably formed entirely in such a form that fibers of the electromagnetic conducting or absorbing fiber convex structure section on one surface can be superposed with by being positioned between fibers of the electromagnetic conducting or absorbing fiber convex structure section on another surface.

In the case of employing the structure-constituting member having a construction in which the electromagnetic conducting or absorbing fiber convex structure section is formed entirely over the surface of the substrate, for example, by controlling (regulating) a density of the electromagnetic conducting or absorbing fiber convex structure section on the surface of the substrate or a density of fibers in the electromagnetic conducting or absorbing fiber convex structure section, it is possible to form the electromagnetic conducting or absorbing fiber convex structure section entirely over the surface of the substrate, in such a form that the fibers of the electromagnetic conducting or absorbing fiber convex structure section on one surface can be superposed with by being positioned between the fibers of the electromagnetic conducting or absorbing fiber convex structure section on the other surface.

Thus, the present invention enables to produce a structure in which the surfaces on each of which the electromagnetic conducting or absorbing fiber convex structure sections is formed are superposed with each other in an opposed manner, by folding or laminating one or a plurality of structure-constituting members having the electromagnetic conducting or absorbing fiber convex structure section at least partially on the substrate (partially or entirely) in such a form that at least a part of a fiber thereof is positioned outward from the surface of the substrate.

Structure-constituting member

The structure-constituting member at least includes a substrate and an electromagnetic conducting or absorbing fiber convex structure section formed on the substrate, and has a construction that the electromagnetic conducting or absorbing fiber convex structure section is formed on the substrate in such a form that at least a part of the fiber thereof is positioned outward from the surface of the substrate.

In case of employing a single structure-constituting member, the structure can be produced by folding such single structure-constituting member in such a form that the surfaces on each of which the electromagnetic conducting or absorbing fiber convex structure sections is formed are superposed with each other in an opposed manner. Also in case of employing a plurality of (two or more) structure-constituting members, the structure can be produced by laminating such plural structure-constituting members (in such case, at least one structure-constituting member may be folded) in such a form that the surfaces on each of which the electromagnetic conducting or absorbing fiber convex structure sections is formed are superposed with each other in an opposed manner.

Electromagnetic conducting or absorbing fiber convex structure section

In such structure-constituting member, the electromagnetic conducting or absorbing fiber convex structure section is not particularly restricted in the form or the construction thereof, as long as the electromagnetic conducting or absorbing fiber convex structure section on the substrate is formed in such a form that at least a part of the fiber thereof is positioned outward from the surface of the substrate and has electromagnetic conducting or absorbing properties. Concretely, examples of the construction of the electromagnetic conducting or absorbing fiber convex structure section include (1) a construction in which the electromagnetic conducting or absorbing fiber convex structure section is formed entirely or partially on the surface of the substrate; and (2) a construction in which a concave is partially formed in the substrate and the electromagnetic conducting or absorbing fiber convex structure section is formed on the wall surface of this concave in a form that at least a part of the fiber thereof is protruded outward (in the external side) from the surface of the substrate.

With respect to the construction of such an electromagnetic conducting or absorbing fiber convex structure section, in the foregoing construction (1), since the electromagnetic conducting or absorbing fiber convex structure section is formed on the surface of the substrate, it may be said that this construction has a portion in which all fibers are positioned outward from the surface of the substrate. Also in the foregoing construction (2), since the electromagnetic conducting or absorbing fiber convex structure section is formed on the wall surface of a concave in the substrate, it may be said that this construction has a portion in which at least a part of the fibers (moreover, a part within one fiber) is positioned outward from the surface of the substrate. In this way, in the electromagnetic conducting or absorbing fiber convex structure section, it is not always required that all fibers are positioned outward (in the external side) from the surface of the substrate. It is only required that at least a part of the fibers (for example, in the case where the electromagnetic conducting or absorbing fiber convex structure section is formed on the wall surface of the concave of the substrate, a fiber formed in an upper part of the wall surface of the concave of the substrate) is positioned outward from the surface of the substrate.

Furthermore, as the fiber which is positioned outward from the surface of the substrate, it is not always required that the full length of one fiber is positioned outward from the surface of the substrate. It is only required that at least a part of one fiber is positioned outward from the surface of the substrate.

In addition, in the case where the electromagnetic conducting or absorbing fiber convex structure section is formed on the wall surface of a concave in the substrate, it is not required that the electromagnetic conducting or absorbing fiber convex structure section is formed on the entire wall surface of the concave of the substrate, and the electromagnetic conducting or absorbing fiber convex structure section may be formed in at least a part of the wall surface of the concave of the substrate.

The electromagnetic conducting or absorbing fiber convex structure section may be a structural section having a shape in which at least a part of the fiber is positioned outward from the surface of the substrate, also having a convex shape formed by the fiber and having electromagnetic conducting or absorbing properties. Examples thereof include a fiber napped section having electromagnetic conducting or absorbing properties (hereinafter also called "electromagnetic conducting or absorbing fiber napped section") of a structure in which the fiber stands up from the surface on which the fiber is formed; and an electromagnetic conducting or absorbing fiber convex structure section of a construction in which a flock of the fiber is disposed on the surface on which the fiber is formed. Concretely, in the case where the electromagnetic conducting or absorbing fiber convex structure section is formed on the surface of the substrate, examples thereof include an electromagnetic conducting or absorbing fiber napped section having a structure in which the fiber stands up from the surface of the substrate; and an electromagnetic conducting or absorbing fiber convex structure section of a construction in which a flock of the fiber is disposed on the surface of the substrate. Furthermore, in the case where the electromagnetic conducting or absorbing fiber convex structure section is formed on the wall surface of a concave in the substrate, examples thereof include an electromagnetic conducting or absorbing fiber napped section having a construction in which at least a part of the fiber stands up from the wall surface of a concave of the substrate and stands up protruded outward from the surface of the substrate (in particular, the end of the fiber is protruded); and an electromagnetic conducting or absorbing fiber convex structure section having a construction in which a flock of the fiber is disposed on the wall surface of a concave of the substrate and a part of the fiber is protruded outward from the surface of the substrate. The electromagnetic conducting or absorbing fiber convex structure section may be constructed of a single structure or a combination of plural structures.

Incidentally, one electromagnetic conducting or absorbing fiber convex structure section is usually constituted of plural fibers. The number and density of the fibers which constitute one electromagnetic conducting or absorbing fiber convex structure section are not particularly limited but can be properly selected depending upon the desired electromagnetic conducting or absorbing properties.

As the electromagnetic conducting or absorbing fiber convex structure section, an electromagnetic conducting and absorbing fiber napped section of a construction in which the fiber stands up from the surface on which the fiber is formed (in particular, the electromagnetic conducting and absorbing fiber napped section having a construction in which the fiber stands up from the surface of the substrate) is preferable.

Examples of the structure of such electromagnetic conducting or absorbing fiber napped section include (1) a construction in which the fiber stands up in a substantially "I" shape and is protruded outward from the surface of the substrate in a state that one of the ends of one fiber is adhered and fixed to a prescribed surface of the substrate (for example, the surface or the wall surface of the concave), while the other end is not fixed (being free); (2) a construction in which the fiber stands up in a substantially "V" shape and is protruded outward from the surface of the substrate in a state that the center of one fiber is adhered to a prescribed surface of the substrate (for example, the surface or the wall surface of the concave), while the both ends of the fiber are not fixed (being free); (3) a construction in which the fiber stands up in a substantially inverted "U" shape and is protruded outward from the surface of the substrate in a state that the both ends of one fiber are adhered and fixed to a prescribed surface of the substrate (for example, the surface or the wall surface of the concave), while the center of the fiber is not fixed (being free); also, a structure in which the fiber stands up in a shape such as a substantially "W" shape, a substantially "M" shape, a substantially "N" shape, and a substantially "O" shape from a prescribed surface of the substrate (for example, the surface or the wall surface of the concave) and is protruded outward from the surface of the substrate; and a combination of these structures. As the electromagnetic conducting or absorbing fiber napped section, the foregoing structure (1) (a structure in which the fiber stands up in a substantially "I" shape from a prescribed surface of the substrate, such as the surface or the wall surface of the concave, and is protruded outward from the surface of the substrate) is preferable.

As a matter of course, the electromagnetic conducting or absorbing fiber napping section may be in a state that the fiber linearly stands up in an "I" shape from a prescribed surface of the substrate (for example, the surface or the wall surface of the concave) and is protruded outward from the surface of the substrate or in a state that the fiber stands up as a whole in a state having a jagged form, a waved line form, a loop form, etc. and is protruded outward from the surface of the substrate.

In the case where the electromagnetic conducting or absorbing fiber convex structure section is partially formed in the substrate, the shape as a whole is not particularly limited, but it may have a prescribed pattern shape. Incidentally, in the case where the electromagnetic conducting or absorbing fiber convex structure section is formed on the wall surface of the concave in the substrate, the shape as a whole in the electromagnetic conducting or absorbing fiber convex structure section as a whole corresponds to the shape of the concave.

The total area of a site in which the electromagnetic conducting or absorbing fiber convex structure section is provided on the substrate (area of the whole electromagnetic conducting or absorbing fiber convex structure sections) is not particularly limited, but, in consideration of the electromagnetic conducting or absorbing properties, an area representing a proportion larger than 0% is desirable with respect to the total surface of one side of the substrate. The area of the whole electromagnetic conducting or absorbing fiber convex structure sections may be suitably selected for example according to the purpose of the structure or a size of the surface area on one surface of the structure. Specifically, in the case that the structure of the invention is utilized as an electromagnetic shield material for an electronic component (particularly an electronic component employed in so-called "mobile phone") or in the case that the structure has a limited surface area on one surface (for example a surface area of 500 $mm^2$ or less), the area of the whole electromagnetic conducting or absorbing fiber convex structure sections is preferably 0.3% or higher, more preferably 30% or higher and particularly preferably 45% or higher. Also in the case that the structure of the invention is utilized as an electromagnetic shield material for a building (for example a use by adhesion to members constituting various surfaces (such as a wall surface, a ceiling surface, a floor surface and the like) of a building, by adhesion in advance to a construction material (such as boards or flooring materials)) or in the case that the structure has a large surface area on one surface (for example a surface area of 0.5 m$^2$ or larger), the area of the whole electromagnetic conducting or absorbing fiber convex structure sections is preferably 0.03% or higher, more preferably 0.1% or higher and particularly 0.3% or higher. In the case that the area of the whole electromagnetic conducting or absorbing fiber convex structure sections on the substrate surface is excessively low with respect to the total surface area on one side of the substrate, electromagnetic conducting or absorbing properties are deteriorated.

Also, the area of each electromagnetic conducting or absorbing fiber convex structure section on the substrate surface or the shortest distance between the electromagnetic conducting or absorbing fiber convex structure sections are not particularly restricted.

Incidentally, as the area of the electromagnetic conducting or absorbing fiber convex structure section on the substrate surface, an area of a portion surrounded by the electromagnetic conducting or absorbing fiber convex structure section can be employed. Therefore, in the case where the electromagnetic conducting or absorbing fiber convex structure section is formed on a wall surface of a concave of the substrate, the area of the electromagnetic conducting or absorbing fiber convex structure section on the substrate surface corresponds to an area of an opening of the concave in the substrate surface.

Such electromagnetic conducting or absorbing fiber convex structure section can be constructed of a fiber having electromagnetic conducting or absorbing properties (hereinafter sometimes referred to as "electromagnetic conducting or absorbing fiber"). The electromagnetic conducting or absorbing fiber is not particularly restricted, and it may be a fiber in which a fiber raw material itself has electromagnetic conducting or absorbing properties (hereinafter also called "electromagnetic conducting or absorbing raw material fiber") or may be a fiber in which electromagnetic conducting or absorbing properties are imparted to the fiber raw material by an electromagnetic conducting or absorbing material (hereinafter also called "electromagnetic conducting or absorbing properties-imparted fiber"). The electromagnetic conducting or absorbing fiber may be used singly or in a combination of two or more kinds thereof.

Incidentally, as the fiber constituting the electromagnetic conducting or absorbing fiber convex structure section, a fiber not having electromagnetic conducting or absorbing properties (hereinafter also called "non-electromagnetic conducting or absorbing fiber") may be used together with the electromagnetic conducting or absorbing fiber. In the case where the non-electromagnetic conducting or absorbing fiber is used together with the electromagnetic conducting or absorbing fiber, the electromagnetic conducting or absorbing fiber and the non-electromagnetic conducting or absorbing fiber may be used as separate yarns or may be used as a single yarn. That is, the electromagnetic conducting or absorbing fiber convex structure section may be constructed by a yarn constituted solely of the electromagnetic conducting or absorbing fiber and a yarn constituted solely of the non-electromagnetic conducting or absorbing fiber or may be constructed of a twisted yarn of the electromagnetic conducting or absorbing fiber and the non-electromagnetic conducting or absorbing fiber. Examples of the non-electromagnetic conducting or absorbing fiber include a cotton fiber, a rayon fiber, a polyamide-based fiber, a polyester-based fiber, a polyacrylonitrile-based fiber, an acrylic fiber, a polyvinyl alcohol fiber, a polyethylene-based fiber, a polyimide-based fiber, a polyolefin-based fiber, a silicone-based fiber, and a fluorine-based resin fiber.

In the electromagnetic conducting or absorbing fiber, a fiber constructed of a material in which the fiber raw material itself has electromagnetic conducting or absorbing properties can be used as the electromagnetic conducting or absorbing raw material fiber. Examples of the electromagnetic conducting or absorbing raw material fiber include a carbon-based fiber, a fiber made of an electrically conductive polymer and a metallic fiber. Examples of the carbon-based fiber include a fiber made of a carbon-based raw material such as carbon black. Also, the electrically conductive polymer in the fiber made of an electrically conductive polymer is not particularly limited, and examples thereof include a polyacetylene-based electrically conductive polymer, a polypyrrole-based electrically conductive polymer, a polyacene-based electrically conductive polymer, a polyphenylene-based electrically conductive polymer, a polyaniline-based electrically conductive polymer, and a polythiophene-based electrically conductive polymer. In addition, the metallic fiber is not particularly limited, and it can be properly selected among fibers made of a metal material as specifically enumerated below. Specific examples of the metallic fiber include fibers made of a metal element such as a gold fiber, a silver fiber, an aluminum fiber, an iron fiber, a copper fiber, a nickel fiber, a stainless steel-based fiber, and a copper-nickel alloy fiber, and fibers made of a metallic compound of any type containing a metal element and a non-metal element such as a copper sulfide fiber.

Furthermore, in the electromagnetic conducting or absorbing fiber, the electromagnetic conducting or absorbing properties-imparted fiber is not particularly restricted so far as it is a fiber in which electromagnetic conducting or absorbing properties are imparted by an electromagnetic conducting or absorbing material. Examples thereof include a fiber coated by an electromagnetic conducting or absorbing material (hereinafter also called "electromagnetic conducting or absorbing material-coated fiber"); a fiber having an electromagnetic conducting or absorbing material impregnated therewith (hereinafter also called "electromagnetic conducting or absorbing material-impregnated fiber"); and a fiber containing an electromagnetic conducting or absorbing material in a fiber raw material (hereinafter also called "electromagnetic conducting or absorbing material-containing raw material fiber").

As the electromagnetic conducting or absorbing properties-imparted fiber, the electromagnetic conducting or absorbing material-coated fiber and the electromagnetic conducting or absorbing material-impregnated fiber can be used advantageously. In the electromagnetic conducting or absorbing material-coated fiber or the electromagnetic conducting or absorbing material-impregnated fiber as the electromagnetic conducting or absorbing properties-imparted fiber, a fiber (fiber raw material) before the electromagnetic conducting or absorbing properties are imparted by the electromagnetic conducting or absorbing material is not particularly limited, and any of a natural fiber, a semi-synthetic fiber, and a synthetic fiber may be employed. Furthermore, the fiber raw material (fiber) may be an electromagnetic conducting or absorbing fiber or may be a non-electromagnetic conducting or absorbing fiber. More specifically, examples of the fiber raw material (fiber) include a non-electromagnetic conducting or absorbing fiber such as a cotton fiber, a rayon fiber, a polyamide-based fiber (for example, an aliphatic polyamide fiber and an aromatic polyamide fiber (so-called aramide fiber)), a polyester-based fiber (such as a trade name "TETRON"), a polyacrylonitrile-based fiber, an acrylic fiber, a polyvinyl alcohol fiber (so-called vinylon fiber), a polyethylene-based fiber, a polyimide-based fiber, a polyolefin-based fiber, a silicone-based fiber, and a fluorine-based resin fiber; and an electromagnetic conducting or absorbing fiber such as a carbon fiber (carbon-based fiber). As the fiber raw material, a non-magnetic conducting or absorbing fiber is preferable; and a cotton fiber, a rayon fiber, a polyamide-based fiber, and a polyester-based fiber are especially preferable. The fiber raw material may be used singly or in a combination of two or more kinds.

Moreover, in the electromagnetic conducting or absorbing material-coated fiber as the electromagnetic conducting or absorbing properties-imparted fiber, the electromagnetic conducting or absorbing material is not particularly limited. For example, in addition to a metal material and a plastic material having electromagnetic conducting or absorbing properties (hereinafter also called "electromagnetic conducting or absorbing plastic material"), a magnetic material of various types can be used. Of these, a metal material can be used advantageously. The electromagnetic conducting or absorbing material can be used singly or in a combination of two or more kinds. In the electromagnetic conducting or absorbing material-coated fiber, the metal material may be a metal material formed by metal elements only such as a metal element or an alloy, or may be a metallic compound of various types containing a non-metal element together with a metal element. As the metal material, a metal material formed solely of metal elements is suitable. Concretely, examples of the metal element in the metal material formed by a metal element only include an element belonging to the Group 1 of the periodic table such as lithium, sodium, potassium, rubidium, and cesium; an element belonging to the Group 2 of the periodic table such as magnesium, calcium, strontium, and barium; an element belonging to the Group 3 of the periodic table such as scandium, yttrium, a lanthanoid element (such as lanthanum and cerium), and an actinoid element (such as actinium); an element belonging to the Group 4 of the periodic table such as titanium, zirconium, and hafnium; an element belonging to the Group 5 of the periodic table such as vanadium, niobium, and tantalum; an element belonging to the Group 6 of the periodic table such as chromium, molybdenum, and tungsten; an element belonging to the Group 7 of the periodic table such as manganese, technetium, and rhenium; an element belonging to the Group 8 of the periodic table such as iron, ruthenium, and osmium; an element belonging to the Group 9 of the periodic table such as cobalt, rhodium, and iridium; an element belonging to the Group 10 of the periodic table such as nickel, palladium, and platinum; an element belonging to the Group 11 of the periodic table such as copper, silver, and gold; an element belonging to the Group 12 of the periodic table such as zinc, cadmium, and mercury; an element belonging to the Group 13 of the periodic table such as aluminum, gallium, indium, and thallium; an element belonging to the Group 14 of the periodic table such as tin and lead; and an element belonging to the Group 15 of the periodic table such as antimony and bismuth). On the other hand, examples of the alloy include stainless steel, a copper-nickel alloy, brass, a nickel-chromium alloy, an iron-nickel alloy, a zinc-nickel alloy, a gold-copper alloy, a tin-lead alloy, a silver-tin-lead alloy, a nickel-chromium-iron alloy, a copper-manganese-nickel alloy, and a nickel-manganese-iron alloy.

Furthermore, the metallic compound containing a non-metal element together with a metal element is not particularly limited so far as it is a metallic compound containing a metal element or an alloy as enumerated previously and capable of exhibiting electromagnetic conducting or absorbing properties. Examples thereof include metal sulfides such s copper sulfide; metal oxides and complex metal oxides such as iron oxide, titanium oxide, tin oxide, indium oxide, and cadmium tin oxide.

Concretely, as the metal material, gold, silver, aluminum, iron, copper, nickel, stainless steel, and a copper-nickel alloy can be advantageously used. In particular, gold, silver, aluminum, copper, nickel, and a copper-nickel alloy can be used advantageously.

Incidentally, examples of the electromagnetic conducting or absorbing plastic material include an electrically conductive plastic material such as a polyacetylene-based conductive polymer, a polypyrrole-based conductive polymer, a polyacene-based conductive polymer, a polyphenylene-based conductive polymer, a polyaniline-based conductive polymer, and a polythiophene-based conductive polymer.

In addition, the magnetic material is not particularly limited, and examples thereof include a soft magnetic powder, various ferrites, and a zinc oxide whisker. As the magnetic material, a ferromagnetic material exhibiting ferromagnetism or ferrimagnetism is suitable. Specific examples of the magnetic material include high-magnetic permeability ferrite (for example so-called "soft ferrite" such as so-called "Mn ferrite", so-called "Ni ferrite", so-called "Zn ferrite", so-called "Mn-Zn ferrite", and so-called "Ni-Zn ferrite"), pure iron, silicon atom-containing iron (such as so-called "silicon steel"), a nickel-iron alloy (for example, so-called "permalloy", a nickel-manganese-iron alloy, a nickel-molybdenum-copper-iron alloy, and a nickel-molybdenum-manganese-iron alloy), an iron-cobalt alloy, an amorphous metal high-magnetic permeability material, an iron-aluminum-silicon alloy (such as so-called "Sendust alloy"), an iron-aluminum-silicon-nickel alloy (such as so-called "Super Sendust alloy"), so-called "ferrite magnet" (for example so-called "hard ferrite", so-called "Ba ferrite" and so-called "Sr ferrite"), so-called "Alnico magnet" (such as an iron-nickel-aluminum-cobalt alloy), an iron-chromium-cobalt alloy, so-called "rare earth cobalt magnet" (such as so-called "Sm-Co magnet" and co-called "2-17 type magnet"), so-called "Nd-Fe-B magnet", so-called "rare earth-iron-nitrogen interstitial compound magnet", and so-called "Mn-Al-C magnet".

In the electromagnetic conducting or absorbing material-coated fiber, a method for coating an electromagnetic conducting or absorbing material on a fiber raw material is not particularly limited, and a known coating method can be properly selected and applied depending upon the type of the electromagnetic conducting or absorbing material. For example, in the case where the electromagnetic conducting or absorbing material is a metal material, as a method for forming the electromagnetic conducting or absorbing material-coated fiber, a coating method by vapor deposition of a metal material or a coating method by plating of a metal material are suitable.

Furthermore, in the electromagnetic conducting or absorbing material-impregnated fiber as the electromagnetic conducting or absorbing properties-imparted fiber, an electromagnetic conducting or absorbing material (for example, a metal material, an electromagnetic conducting or absorbing plastic material, and a magnetic material) same as the electromagnetic conducting or absorbing material in the foregoing electromagnetic conducting or absorbing material-coated fiber can be used as the electromagnetic conducting or absorbing material, and a metal material (in particular, gold, silver, aluminum, copper, nickel, and a copper-nickel alloy) can be used advantageously. In the electromagnetic conducting or absorbing material-impregnated fiber, a method for impregnating the fiber raw material with the electromagnetic conducting or absorbing material is not particularly limited, and a known impregnation method can be properly selected and applied depending upon the type of the electromagnetic conducting or absorbing material. For example, in the case where the electromagnetic conducting or absorbing material is a metal material, as the method for forming the electromagnetic conducting or absorbing material-impregnated fiber, an impregnation method of dipping the fiber raw material into the metal material is advantageous.

Also, in the electromagnetic conducting or absorbing material-containing raw material fiber as the electromagnetic conducting or absorbing properties-imparted fiber, an electromagnetic conducting or absorbing material (for example, a metal material, an electromagnetic conducting or absorbing plastic material, and a magnetic material) same as the electromagnetic conducting or absorbing material in the foregoing electromagnetic conducting or absorbing material-coated fiber can be used as the electromagnetic conducting or absorbing material, and a metal material (in particular, gold, silver, aluminum, copper, nickel, and a copper-nickel alloy) can be used advantageously. The electromagnetic conducting or absorbing material such as a metal material may have any form such as a powder form, a film form, a foil form, a thin layer form, and a fibrous form. Furthermore, as a material of the fiber raw material in the electromagnetic conducting or absorbing material-containing raw material fiber, a plastic material (for example, polyamide, polyester, polyacrylonitrile, an acrylic resin, polyvinyl alcohol, polyethylene, polyimide, a polyolefin-based resin, a silicone-based resin, and a fluorine-based resin) can be used advantageously. In the electromagnetic conducting or absorbing material-containing raw material fiber, a method for including the electromagnetic conducting or absorbing material in the fiber raw material is not particularly limited, and a known including method can be properly selected and applied depending upon the type of the electromagnetic conducting or absorbing material. For example, there can be employed a method for including the electromagnetic conducting or absorbing material in the fiber raw material by mixing a material of the fiber raw material with the electromagnetic conducting or absorbing material for example by kneading, and then fibrillating the mixture.

In the invention, as the electromagnetic conducting or absorbing fiber, at least one kind of a fiber selected from an electromagnetic conducting or absorbing material-coated fiber, an electromagnetic conducting or absorbing material-impregnated fiber, and an electromagnetic conducting or absorbing raw material fiber can be used advantageously. Accordingly, the electromagnetic conducting or absorbing fiber convex structure section can be advantageously constructed of at least one kind of a fiber selected from an electromagnetic conducting or absorbing material-coated fiber, an electromagnetic conducting or absorbing material-impregnated fiber, and an electromagnetic conducting or absorbing raw material fiber.

As such electromagnetic conducting or absorbing fiber (or fiber raw material), a short fiber can be used advantageously. When the length of the electromagnetic conducting or absorbing fiber is long, the electromagnetic conducting or absorbing fiber convex structure section is liable to tumble. It is desired that the electromagnetic conducting or absorbing fiber (or fiber raw material) has a length of from about 0.1 to 5 mm (preferably from 0.3 to 5 mm, and more preferably from 0.3 to 2 mm). Also when the length of the electromagnetic conducting or absorbing fiber is too short, the production becomes difficult and the costs become high, and therefore, such is not preferable from the viewpoint of cost.

Furthermore, the thickness of the electromagnetic conducting or absorbing fiber (fiber raw material) is not particularly limited, and it can for example be selected within the range of from about 0.1 to 20 deniers (preferably from 0.5 to 15 deniers, and more preferably from 1 to 6 deniers). An excessively large thickness of the electromagnetic conducting or absorbing fiber for example reduces a bending property and a flexibility of the structure. On the other hand, an excessively small thickness of the electromagnetic conducting or absorbing fiber undesirably deteriorates the handling properties.

Also the thickness of the electromagnetic conducting or absorbing fiber (fiber raw material) may be defined or selected by a diameter thereof. The diameter of the electromagnetic conducting or absorbing fiber may be selected for example within a range of from 5 to 100 $\mu$m, preferably from 10 to 50 $\mu$m and more preferably from 15 to 45 $\mu$m.

Incidentally, as the electromagnetic conducting or absorbing fiber, two or more kinds of electromagnetic conducting or absorbing fibers or an electromagnetic conducting or absorbing fiber using two or more kinds of electromagnetic conducting or absorbing materials are preferably used. In particular, two or more kinds of electromagnetic conducting or absorbing fibers can be used advantageously. In the case where two or more kinds of electromagnetic conducting or absorbing fibers are used as the electromagnetic conducting or absorbing fiber, the two or more kinds of electromagnetic conducting or absorbing fibers may be used as separate yarns or may be used as a single yarn. Thus, the electromagnetic conducting or absorbing fiber convex structure section may be constructed of two or more kinds of yarns formed by two or more kinds of electromagnetic conducting or absorbing fibers or may be constructed of a twisted yarn utilizing two or more kinds of electromagnetic conducting or absorbing fibers. In this way, by using two or more kinds of electromagnetic conducting or absorbing fibers or the like as the electromagnetic conducting or absorbing fiber, it is possible to obtain a structure matching a wide range of electromagnetic waves as described below.

A method for forming the electromagnetic conducting or absorbing fiber convex structure section (in particular, the electromagnetic conducting or absorbing fiber napped section) is not particularly restricted, but a flocking method (in particular, an electrostatic flocking method) can be advantageously applied as described below. As the foregoing electrostatic flocking method, any of an up method, a down method and a side method may be employed. In case of forming the electromagnetic conducting or absorbing fiber convex structure section in a prescribed site on the surface of the substrate by the flocking method, it is preferable to execute the flocking after positioning a member having a hole section (penetrating hole section) in a prescribed position for forming the electromagnetic conducting or absorbing fiber convex structure section on the substrate surface (particularly a releasable liner having a penetrating hole section), on a prescribed position on the substrate surface. Also in case of forming the electromagnetic conducting or absorbing fiber convex structure section on a wall surface of a concave on the substrate by the flocking method, it is preferable to execute the flocking after positioning a member having a hole section (penetrating hole section) in a position corresponding to the concave of the substrate (concave for forming the electromagnetic conducting or absorbing fiber convex structure section (particularly a releasable liner having a penetrating hole section), on a prescribed position on the substrate surface.

Substrate

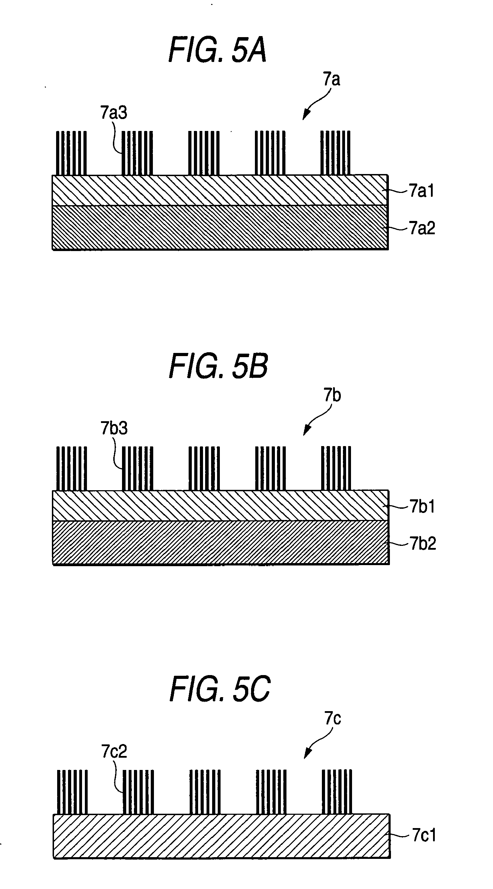

In the structure-constituting member, the substrate for forming the electromagnetic conducting or absorbing fiber convex structure section is not particularly restricted so far as it can secure a fluidity and a pressure-sensitive adhesive property or an adhesive property (pressure-sensitive adhesive or adhesive property) at the formation of the electromagnetic conducting or absorbing fiber convex structure section. The substrate may have either of a single-layered form and a laminated form. In the invention, as the substrate, a pressure-sensitive adhesive layer, an adhesive layer or a polymer may be employed advantageously, as illustrated in Figs. 5A to 5C, and a pressure-sensitive adhesive layer or an adhesive layer (also called "pressure-sensitive adhesive or adhesive layer") is advantageous. Figs. 5A to 5C are schematic cross-sectional views illustrating examples of the structure-constituting member in the present invention, wherein illustrated are a structure-constituting member 7a, a pressure-sensitive adhesive or adhesive layer (pressure-sensitive adhesive layer or adhesive layer) 7a1, a base material 7a2, an electromagnetic conducting or absorbing fiber napped section 7a3, a structure-constituting member 7b, a pressure-sensitive adhesive layer 7b1, a release liner 7b2, an electromagnetic conducting or absorbing fiber napped section 7b3, a structure-constituting member 7c, a polymer layer 7c 1, and an electromagnetic conducting or absorbing fiber napped section 7c2. The structure-constituting member 7a illustrated in Fig. 5A has a construction that a pressure-sensitive adhesive or adhesive layer 7a1 is formed as a substrate on a surface of the base material 7a2 as a support, and an electromagnetic conducting or absorbing fiber napped section 7a3 is formed as the electromagnetic conducting or absorbing fiber convex structure section, partially on the surface of such pressure-sensitive adhesive or adhesive layer 7a1. The structure-constituting member 7b illustrated in Fig. 5B has a construction that a pressure-sensitive adhesive layer 7b 1 is formed as a substrate on a surface of the release liner 7b2 as a support, and an electromagnetic conducting or absorbing fiber napped section 7b3 is formed as the electromagnetic conducting or absorbing fiber convex structure section, partially on the surface of such pressure-sensitive adhesive layer 7b 1. The structure-constituting member 7c illustrated in Fig. 5C has a construction that an electromagnetic conducting or absorbing fiber napped section 7c2 is formed as the electromagnetic conducting or absorbing fiber convex structure section, partially on the surface of a polymer layer 7c 1 as the substrate.

The structure of the invention (namely a structure of a construction that the surfaces on the sides having the electromagnetic conducting or absorbing fiber convex structure sections are superposed with each other in an opposed manner) can be prepared by folding each of the structure-constituting members 7a to 7c illustrated in Figs. 5A to 5C, or by laminating each of the structure-constituting members 7a to 7c illustrated in Figs. 5A to 5C with another structure-constituting member.

In such pressure-sensitive adhesive or adhesive layer (pressure-sensitive adhesive or adhesive layer) as the substrate, the pressure-sensitive adhesive which constitutes the pressure-sensitive adhesive layer is not particularly limited, and examples thereof include known pressure-sensitive adhesives such as a rubber-based pressure-sensitive adhesive, an acrylic pressure-sensitive adhesive, a polyester-based pressure-sensitive adhesive, an urethane-based pressure-sensitive adhesive, a polyamide-based pressure-sensitive adhesive, an epoxy-based pressure-sensitive adhesive, a vinyl alkyl ether-based pressure-sensitive adhesive, a silicone-based pressure-sensitive adhesive, and a fluorine-based pressure-sensitive adhesive. Furthermore, the pressure-sensitive adhesive may be a hot melt type pressure-sensitive adhesive. On the other hand, the adhesive which constitutes the adhesive layer is not particularly limited, and examples thereof include known adhesives such as a rubber-based adhesive, an acrylic adhesive, a polyester-based adhesive, an urethane-based adhesive, a polyamide-based adhesive, an epoxy-based adhesive, a vinyl alkyl ether-based adhesive, a silicone-based adhesive, and a fluorine-based adhesive. Moreover, the adhesive may be a heat-sensitive adhesive. The pressure-sensitive adhesive or adhesive can be used singly or in a combination of two or more kinds thereof. The pressure-sensitive adhesive or adhesive may be a pressure-sensitive adhesive or adhesive of any form such as an emulsion type form, a solvent type form, an oligomer type form, and a solid type form.

Incidentally, the pressure-sensitive adhesive or adhesive may contain, in addition to a polymer component (base polymer) such as a pressure-sensitive adhesive component or an adhesive component, appropriate additives such as a crosslinking agent (for example, a polyisocyanate-based crosslinking agent and an alkyl etherified melamine compound-based crosslinking agent), a tackifier (for example, a rosin derivative resin, a polyterpene resin, a petroleum resin, and a phenol resin), a plasticizer, a filler, and an antiaging agent depending upon the type of the pressure-sensitive adhesive or adhesive and the like. In the case of performing crosslinking in forming the pressure-sensitive adhesive layer or adhesive layer, a known crosslinking method such as a heat crosslinking method by heating, an ultraviolet ray crosslinking method by irradiation with ultraviolet rays (UV crosslinking method), an electron beam crosslinking method by irradiation with electron beams (EB crosslinking method), and a spontaneous curing method for achieving spontaneous curing at the room temperature, and the like can be applied.

In the invention, a pressure-sensitive adhesive layer is suitable as the pressure-sensitive adhesive or adhesive layer. As the pressure-sensitive adhesive which constitutes the pressure-sensitive adhesive layer, a rubber-based pressure-sensitive adhesive or an acrylic pressure-sensitive adhesive can be used advantageously.

As a method of forming the pressure-sensitive adhesive or adhesive layer, a known method for forming a pressure-sensitive adhesive layer or a known method for forming an adhesive layer (for example, a coating method or a transfer method) can be employed. The forming method can be properly selected depending upon the type, shape and size of the support for forming the structure-constituting member or the pressure-sensitive adhesive or adhesive layer. For example in the case where the pressure-sensitive adhesive layer is formed on the substrate as a support, examples of the method for forming the pressure-sensitive adhesive layer include a method of coating a pressure-sensitive adhesive on the substrate (coating method); and a method of coating a pressure-sensitive adhesive on a release film such as a release liner to form a pressure-sensitive adhesive layer and then transferring this pressure-sensitive adhesive layer onto the substrate (transfer method). Also in the case where the pressure-sensitive adhesive layer is formed on a release liner as described in the following, examples of the method for forming the pressure-sensitive adhesive layer include a method of coating a pressure-sensitive adhesive on the releasing surface of the release liner (coating method). Also examples of the method for forming an adhesive layer include, in the case that the adhesive layer is formed on a substrate as a support, a method of coating an adhesive on a prescribed surface of the substrate (coating method).

On the other hand, a polymer component for constructing the polymer layer is not particularly limited, and one or two or more kinds of known polymer components (for example, a resin component such as a thermoplastic resin, a thermosetting resin or an ultraviolet ray-curable resin, a rubber component, and an elastomer component) can be properly selected and used. Concretely, in the polymer component which constructs the polymer layer, examples of the resin component include an acrylic resin, a styrene-based resin, a polyester-based resin, a polyolefin-based resin, polyvinyl chloride, a vinyl acetate-based resin, a polyamide-based resin, a polyimide-based resin, a urethane-based resin, an epoxy-based resin, a fluorine-based resin, a silicone-based resin, polyvinyl alcohol, polycarbonate, polyacetal, polyetherimide, polyamide-imide, polyesterimide, polyphenylene ether, polyphenylene sulfide, polyethersulfone, polyetheretherketone, polyetherketone, polyallylate, polyaryl, and polysulfone. Furthermore, examples of the rubber component include natural rubber and synthetic rubber (for example, polyisobutylene, polyisoprene, chloroprene rubber, butyl rubber, and nitrile butyl rubber). Moreover, examples of the elastomer component include a variety of thermoplastic elastomers such as an olefin-based thermoplastic elastomer, a styrene-based thermoplastic elastomer, a polyester-based thermoplastic elastomer, a polyamide-based thermoplastic elastomer, a polyurethane-based thermoplastic elastomer, and an acrylic thermoplastic elastomer.

The thickness of the substrate (pressure-sensitive adhesive or polymer layer) is not particularly limited, and it may be selected within a range of from about 1 to 1,000 $\mu$m (preferably from 10 to 500 $\mu$m).

Incidentally, in the substrate (particularly pressure-sensitive adhesive layer), a concave may be partially formed. Though such a concave may be a depressed section, it is preferably a hole section (through-hole section). In the hole section, a perforated section is especially suitable. In such a concave, it is possible to adapt the shape of the concave as the whole, the shape of an opening of each concave in the surface of the substrate, the whole area of the openings of the respective concaves in the surface of the substrate, and the area of an opening of each concave in the surface of the substrate, with the aforementioned electromagnetic conducting or absorbing fiber convex structure section. In the case where the concave is a depressed section, its depth is not particularly limited and can be properly selected within a depth range corresponding to 1% or more (for example, from 1 to 99%, and preferably from 30 to 90%) of the thickness of the substrate.

Furthermore, the pressure-sensitive adhesive layer as the substrate can be formed on a release liner. In this case, a depressed section as the concave can be formed on at least one surface of the pressure-sensitive adhesive layer, and preferably on one surface of the pressure-sensitive adhesive layer. Moreover, the pressure-sensitive adhesive layer as the substrate may be formed on each of both surfaces of the base material as a support. In this case, the concave (such as a depressed section or a hole section) can be formed on the surface of at least either one pressure-sensitive adhesive layer, and preferably on the surface of the pressure-sensitive adhesive layer at one side.

In the case where the concave is a hole section, examples of a method for forming the hole section include a perforating method utilizing a known and/or usual hole section forming machine (above all, a perforation forming machine having a convex structure of various shapes (protruded structure) and a concave structure counterpart to the convex structure), a perforating method by heat or light beam (for example, a perforating method by a thermal head, a halogen lamp, a xenon lamp, a flash lamp, or a laser beam), and a molding method utilizing a mold (for example, a mold having a convex). In the case where the concave is a depressed section, as a method for forming a depressed section, a forming method same as in forming a hole section can be employed.

In the invention, it is preferable that the substrate (such as pressure-sensitive adhesive or adhesive layer or polymer layer) has electromagnetic conducting or absorbing properties from the viewpoint of further improving the electromagnetic conducting or absorbing properties of the structure. The substrate having electromagnetic conducting or absorbing properties can be formed from a composition containing an electromagnetic conducting or absorbing material (for example, a pressure-sensitive adhesive composition, an adhesive composition, or a polymer composition). The electromagnetic conducting or absorbing material which is used in the substrate is not particularly limited. For example, one or two or more kinds of an electromagnetic conducting or absorbing material such as a metal material, an electromagnetic conducting or absorbing plastic material (such as an electrically conductive plastic material), and a magnetic material may be employed. Incidentally, examples of the metal material, the electromagnetic conducting or absorbing material and the magnetic material include the above-enumerated metal material, electromagnetic conducting or absorbing material and magnetic material (for example, a metal material, an electromagnetic conducting or absorbing plastic material, and a magnetic material as enumerated in the electromagnetic conducting or absorbing fiber for constructing the electromagnetic conducting or absorbing fiber convex structure section). The electromagnetic conducting or absorbing material such as a metal material, an electromagnetic conducting or absorbing plastic material or a magnetic material may have any form such as a powder form, a film form, a foil form, a thin layer form, and a fibrous form.

The substrate containing the electromagnetic conducting or absorbing material (such as a pressure-sensitive adhesive composition, an adhesive composition or a polymer composition) can be prepared by mixing a pressure-sensitive adhesive for forming a pressure-sensitive adhesive layer, an adhesive for forming an adhesive layer or a polymer component for forming a polymer layer, and an electromagnetic conducting or absorbing material. The content proportion of the electromagnetic conducting or absorbing material is not particularly limited and can be properly selected depending upon the pressure-sensitive adhesivity or adhesivity of the pressure-sensitive adhesive or adhesive, and the electromagnetic conducting or absorbing property of the pressure-sensitive adhesive or adhesive layer or the polymer layer, and it is preferably from 3 to 98% by weight (in particular, from 5 to 95% by weight) with respect to the total amount of solids in the pressure-sensitive adhesive composition, adhesive composition or polymer composition. An excessively low content proportion of the electromagnetic conducting or absorbing material reduces the electromagnetic conducting or absorbing properties of the substrate, while an excessively high content proportion reduces the pressure-sensitive adhesive or adhesive property, when the substrate is a pressure-sensitive adhesive or adhesive layer.

Support

In such structure-constituting member, the substrate (particularly the pressure-sensitive adhesive or adhesive layer as the substrate) may be formed on at least one surface of a support. In the case that the substrate is formed on both surfaces of the support, the electromagnetic conducting or absorbing fiber convex structure section may be formed on only the substrate formed on one surface of the support, or the electromagnetic conducting or absorbing fiber convex structure section may be formed on the substrates formed on both surfaces of the support.

Such support is not particularly limited and may be suitably selected for example according to the type of the structure. The support may have any form, and examples thereof include spherical, cylindrical, polygonal, polygonal conical, conical, tabular, and sheet-like forms. Also the material of the support is not particularly restricted, and may be any material such as a plastic material, a metal material, a fibrous material or a paper material, and such materials may be used singly or in a combination of two or more types.

In the present invention, the support preferably has a sheet-like form. In the case that the support has a sheet-like form, a structure formed by folding or laminating one or plural structure-constituting members can be utilized as a sheet-like structure having a sheet-like form. Examples of the support having such sheet-like form include, in the case that the substrate is a pressure-sensitive adhesive or adhesive layer, a sheet-like base material such as a base material for a pressure-sensitive adhesive tape or sheet, and a release liner for a pressure-sensitive adhesive tape or sheet. More specifically, in the case that the structure-constituting member is formed as a pressure-sensitive adhesive tape or sheet of a base material-including type having the pressure-sensitive adhesive layer on one side or on both sides, a base material for the pressure-sensitive adhesive tape or sheet may be used as the support. Also in the case that the structure-constituting member is formed as a double-sided pressure-sensitive adhesive tape or sheet of a base material-less type, a release liner (separator) for the pressure-sensitive adhesive tape or sheet may be used as the support. In the case that the structure-constituting member is formed as a pressure-sensitive adhesive tape or sheet of a base material-including type having the pressure-sensitive adhesive layer on one side or on both sides, the structure-constituting member may have a construction in which the pressure-sensitive adhesive layer is formed on one surface or both surfaces of a base material (base material for pressure-sensitive adhesive tape or sheet) as the support and the electromagnetic conducting or absorbing fiber convex structure section is formed on a surface or a wall surface of a concave formed on a surface of the pressure-sensitive adhesive layer, formed on one or both surfaces of the base material. On the other hand, in the case that the structure-constituting member is formed as a double-sided pressure-sensitive adhesive tape or sheet of a base material-less type, the structure-constituting member may have a construction in which a release liner (release liner for pressure-sensitive adhesive tape or sheet) is used as the support for the pressure-sensitive adhesive layer and the electromagnetic conducting or absorbing fiber convex structure section is formed on a surface or a wall surface of a concave formed on a surface of the pressure-sensitive adhesive layer. The release liner as the support supports the pressure-sensitive adhesive layer until the structure-constituting member is used and protects the surface of the pressure-sensitive adhesive layer.

Base material

As the base material serving as a support, a sheet-like base material can be employed advantageously, as described above. For such sheet-like base material, a base material for a pressure-sensitive adhesive tape or sheet (base material) can be used advantageously. As the base material, an appropriate thin sheet member for example a plastic base material such as a plastic film or sheet; a metallic base material such as a metal foil or a metal plate; a paper-based base material for example paper (such as wood-free paper, Japanese paper, kraft paper, glassine paper, synthetic paper, and topcoat paper); a fibrous base material such as a cloth, a non-woven cloth, or a net; a rubber-based base material such as a rubber sheet; and a foamed member such as a foamed sheet, can be used. The base material may have a single-layered form or a laminated form. For example, the base material may be a multilayered member (two- or three-layered composite member) of a plastic base material and another base material (such as a metallic base material, a paper-based base material, or a fibrous base material) formed by lamination, co-extrusion, or the like. A foamed member employed as the substrate allows to improve the adaptability to the surface irregularities of an adhered member.

The base material is preferably a plastic base material such as a plastic film or sheet. Examples of a raw material (plastic material) for such plastic base material include an olefin-based resin composed of an $\alpha$-olefin as a monomer component, such as polyethylene (PE), polypropylene (PP), an ethylene-propylene copolymer, or an ethylene-vinyl acetate copolymer (EVA); a polyester-based resin such as polyethylene terephthalate (PET), polyethylene naphthalate (PEN), or polybutylene terephthalate (PBT); polyvinyl chloride (PVC); a vinyl acetate-based resin; polyphenylene sulfide (PPS); an amide-based resin such as a polyamide (nylon) or a wholly aromatic polyamide (aramid); a polyimide-based resin; and polyetheretherketone (PEEK). Furthermore, in the base material, the plastic material of the plastic base material may be an electromagnetic conducting or absorbing plastic material (for example an electrically conductive plastic material). Examples of the electrically conductive plastic material include an electrically conductive polymer as enumerated previously in the electromagnetic conductive or absorbing fiber. The plastic material may be used singly or in a mixed state of a combination of two or more kinds. Incidentally, the plastic film or sheet may be of a non-stretched type or a stretched type having been subjected to a uniaxial or biaxial stretching treatment.

Furthermore, examples of the metal material for forming the metallic base material (for example, a metal foil and a metal plate) include metal materials as enumerated previously in the electromagnetic conducting or absorbing fiber. The metal material can be used singly or in a combination of two or more kinds thereof.

In the invention, for the purpose of further enhancing the electromagnetic conducting or absorbing properties of the structure, a base material having electromagnetic conducting or absorbing properties (also called "electromagnetic conducting or absorbing base material") can be used advantageously as the base material. The electromagnetic conducting or absorbing base material is not particularly restricted so far as it can exhibit electromagnetic conducting or absorbing properties, and examples thereof include a base material constituted of a electromagnetic conducting or absorbing material and a base material containing a electromagnetic conducting or absorbing material on a surface or in the interior.

In the electromagnetic conducting or absorbing base material, the base material constituted of an electromagnetic conducting or absorbing material is not particularly limited. For example, an electromagnetic conducting or absorbing material such as a metal material, an electromagnetic conducting or absorbing plastic material (for example, an electrically conductive plastic material), and a magnetic material can be used singly or in a combination of two or more kinds. Incidentally, examples of the metal material, the electromagnetic conducting or absorbing plastic material, and the magnetic material include an electromagnetic conducting or absorbing fiber which constructs the electromagnetic conducting or absorbing fiber convex structure section, and a metal material, an electromagnetic conducting or absorbing plastic material, and a magnetic material as enumerated in the electromagnetic conducting or absorbing material to be contained in the pressure-sensitive adhesive composition or adhesive composition.

Furthermore, the base material containing an electromagnetic conducting or absorbing material on the surface or inside thereof is not particularly limited so far as it is a base material of any kind in which an electromagnetic conducting or absorbing material is used on the surface or inside thereof. Examples of the base material containing an electromagnetic conducting or absorbing material on the surface thereof include a base material having a layer made of an electromagnetic conducting or absorbing material-containing composition containing an electromagnetic conducting or absorbing material (hereinafter also called "electromagnetic conducting or absorbing material-containing layer") on the surface thereof. In the base material having an electromagnetic conducting or absorbing material-containing layer on the surface thereof, it is only required that the electromagnetic conducting or absorbing material-containing layer is formed on at least one surface of the base material. Furthermore, the thickness of the electromagnetic conducting or absorbing material-containing layer is not particularly limited. For example, it can be properly selected within the range of 0.1 μm or more (for example, from 0.1 μm to 1 mm) and the electromagnetic conducting or absorbing material-containing layer may be a thin layer (for example, a thin film layer having a thickness of from about 0.1 to 30 μm). Accordingly, the base material having an electromagnetic conducting or absorbing material-containing layer on the surface thereof may be a base material having a construction in which an electromagnetic conducting or absorbing material-containing layer having a thin thickness is formed on a base material not having the electromagnetic conducting or absorbing properties (hereinafter also called "non-electromagnetic conducting or absorbing base material") or may be a base material having a construction in which a non-electromagnetic conducting or absorbing base material and an electromagnetic conducting or absorbing material-containing layer are laminated.

In an electromagnetic conducting or absorbing material-containing composition for forming such an electromagnetic conducting or absorbing material-containing layer, the electromagnetic conducting or absorbing material may be contained as a principal component or a mixing component (sub-component). The electromagnetic conducting or absorbing material is not particularly limited and examples thereof include a metal material, an electromagnetic conducting or absorbing plastic material (for example, an electrically conducting plastic material), and a magnetic material. Accordingly, the electromagnetic conducting or absorbing material-containing layer may be a metal material layer such as a metal foil or a metal plate, an electromagnetic conducting or absorbing plastic material layer such as an electromagnetic conducting or absorbing plastic material-made film or sheet, or a magnetic material layer. Incidentally, examples of the metal material for forming the electromagnetic conducting or absorbing material-containing layer include a metal material as enumerated previously in the electromagnetic conducting or absorbing fiber which constructs the electromagnetic conducting or absorbing fiber convex structure section. Furthermore, examples of the electromagnetic conducting or absorbing plastic material include an electromagnetic conducting or absorbing plastic material as enumerated previously in the electromagnetic conducting or absorbing fiber which constructs the electromagnetic conducting or absorbing fiber convex structure section. Moreover, examples of the magnetic material include a magnetic material as enumerated previously in the electromagnetic conducting or absorbing fiber which constructs the electromagnetic conducting or absorbing fiber convex structure section. The electromagnetic conducting or absorbing material can be used singly or in a combination of two or more kinds thereof. Incidentally, the electromagnetic conducting or absorbing material such as a metal material, an electromagnetic conducting or absorbing plastic material, or a magnetic may have any form such as a powder form, a film-like form, a foil-like form, or a thin layer-like form.

Furthermore, the non-electromagnetic conducting or absorbing base material to be coated or laminated by the electromagnetic conducting or absorbing material is not particularly limited so far as it is a base material not having electromagnetic conducting or absorbing properties. Examples thereof include a plastic base material not having electromagnetic conducting or absorbing properties (for example, a plastic base material constituted of, as a raw material, a resin not having electromagnetic conducting or absorbing properties such as a polyolefin-based resin, a polyester-based resin, polyvinyl chloride, a vinyl acetate-based resin, polyphenylene sulfide, an amide-based resin, a polyimide-based resin, and polyetheretherketone); a paper-based base material not having electromagnetic conducting or absorbing properties (such as wood-free paper, Japanese paper, kraft paper, glassine paper, synthetic paper, or topcoat paper); and a fibrous base material not having electromagnetic conducting or absorbing properties (such as a cloth or non-woven cloth not having electromagnetic conducting or absorbing properties). Incidentally, the non-electromagnetic conducting or absorbing base material may have a single-layered form or a laminated form.

Incidentally, in the base material having an electromagnetic conducting or absorbing material-containing layer on the surface thereof, a method for forming an electromagnetic conducting or absorbing material-containing material on the surface of the base material is not particularly limited and can be properly selected and applied from a known method (for example, a metal vapor deposition method, a metal plating method, a lamination method by adhesion, an impregnation method, and a coating method) depending upon the type of the electromagnetic conducting or absorbing material, the thickness of the electromagnetic conducting or absorbing material-containing layer, and the like. For example, in the case where the electromagnetic conducting or absorbing material is a metal material and the electromagnetic conducting or absorbing material-containing layer is an electromagnetic conducting or absorbing material-containing layer having a thin thickness, the electromagnetic conducting or absorbing material-containing layer can be formed on the surface of the base material by applying a coating method by vapor deposition of a metal material, a coating method by plating of a metal material, and the like. Accordingly, the base material having an electromagnetic conducting or absorbing material-containing layer on the surface thereof may be a plastic film or sheet having a metal material vapor-deposited on the surface thereof (a metal vapor-deposited plastic film or sheet) or a plastic film or sheet having a metal material plated on the surface thereof (a metal plated plastic film or sheet).

On the other hand, examples of the base material containing an electromagnetic conducting or absorbing material in the inside thereof include a base material which is formed of an electromagnetic conducting or absorbing material-containing composition containing an electromagnetic conducting or absorbing material. Such a base material may be a base material in which an electromagnetic conducting or absorbing material is formed as a principal material which constructs the base material (hereinafter also called "electromagnetic conductive or absorbing material-based base material") or a base material formed of a mixed material containing a principal material which constructs the base material and an electromagnetic conducting or absorbing material (hereinafter also called "electromagnetic conducting or absorbing material-containing base material"). Examples of the electromagnetic conducting or absorbing material-based base material include a metallic base material such as a metal foil or a metal plate; an electromagnetic conducting or absorbing plastic base material such as a film or sheet formed of an electromagnetic conducting or absorbing plastic material; a fibrous base material having electromagnetic conducting or absorbing properties (electromagnetic conducting or absorbing fibrous base material) for example a woven fabric (such as a cloth) or non-woven fabric formed of a fiber having electromagnetic conducting or absorbing properties; and a magnetic material-based base material such as a magnetic material plate. Examples of a metal material for forming the metallic base material include a metal material as enumerated previously in the electromagnetic conducting or absorbing fiber which constructs the electromagnetic conducting or absorbing fiber convex structure section. Furthermore, examples of an electromagnetic conducting or absorbing plastic material for forming the electromagnetic conducting or absorbing plastic base material include an electromagnetic conducting or absorbing plastic material as enumerated previously in the electromagnetic conducting or absorbing fiber which constructs the electromagnetic conducting or absorbing fiber convex structure section. Moreover, examples of a fiber in the electromagnetic conducting or absorbing fibrous base material include an electromagnetic conducting or absorbing fiber (such as a carbon-based fiber, a fiber made of an electrically conductive polymer, or a metallic fiber) as enumerated previously in the electromagnetic conducting or absorbing fiber which constructs the electromagnetic conducting or absorbing fiber convex structure section. In addition, examples of a magnetic material in the magnetic material-based base material include a magnetic material as enumerated previously in the electromagnetic conducting or absorbing fiber which constructs the electromagnetic conducting or absorbing fiber convex structure section.

Furthermore, in the electromagnetic conducting or absorbing material-containing base material, examples of the principal material which constitutes the base material include a material not having electromagnetic conducting or absorbing properties (hereinafter also called "non-electromagnetic conducting or absorbing material"), for example a plastic material not having electromagnetic conducting or absorbing properties (for example a resin not having electromagnetic conducting or absorbing properties such as a polyolefin-based resin, a polyester-based resin, polyvinyl chloride, a vinyl acetate-based resin, polyphenylene sulfide, an amide-based resin, a polyimide-based resin, or polyetheretherketone); a paper material not having electromagnetic conducting or absorbing properties (for example a paper material capable of forming a paper-based base material not having electromagnetic conducting or absorbing properties such as wood-free paper, Japanese paper, kraft paper, glassine paper, synthetic paper, or topcoat paper); and a fiber material not having electromagnetic conducting or absorbing properties (for example a fiber material capable of forming a fibrous base material not having electromagnetic conducting or absorbing properties such as a cloth or a non-woven cloth not having electromagnetic conducting or absorbing properties). The non-electromagnetic conducting or absorbing material may be used singly or in a combination of two or more kinds. Examples of the electromagnetic conducting or absorbing material in the electromagnetic conducting or absorbing material-containing base material include a metal material as enumerated previously in the electromagnetic conducting or absorbing fiber which constructs the electromagnetic conducting or absorbing fiber convex structure section, an electromagnetic conducting or absorbing plastic material as enumerated previously in the electromagnetic conducting or absorbing fiber which constructs the electromagnetic conducting or absorbing fiber convex structure section, and a magnetic material as enumerated previously in the electromagnetic conducting or absorbing fiber which constructs the electromagnetic conducting or absorbing fiber convex structure section.

Incidentally, in the electromagnetic conducting or absorbing material-containing base material, in the case where the principal material which constitutes the base material is a fiber material not having electromagnetic conducting or absorbing properties, the electromagnetic conducting or absorbing material may be contained in a form impregnated in the fiber or in a form mixed in the fiber material constituting the fiber.

In the base material containing an electromagnetic conducting or absorbing material in the inside thereof, a method for containing the electromagnetic conducting or absorbing material in the inside of the base material is not particularly limited. For example, in the case where the base material containing an electromagnetic conducting or absorbing material in the inside thereof is an electromagnetic conducting or absorbing material-based base material, it is possible to form the electromagnetic conducting or absorbing material-based base material by applying a known method for forming a metal foil, a known method for forming a plastic film or sheet, a known method forming a fiber, or the like depending upon the type of the electromagnetic conducting or absorbing material-based base material, etc. Furthermore, in the case where the base material containing an electromagnetic conducting or absorbing material in the inside thereof is an electromagnetic conducting or absorbing material-containing base material, for example, after mixing the principal material constituting the base material with the electromagnetic conducting or absorbing material, the electromagnetic conducting or absorbing material-containing base material can be formed by applying a known method for forming a metal foil, a known method for forming a plastic film or sheet, or the like depending upon the types of the principal material constituting the base material and the electromagnetic conducting or absorbing material.

Incidentally, if desired, the electromagnetic conducting or absorbing base material may contain a variety of additives such as an inorganic filler (such as titanium oxide or zinc oxide), an antiaging agent (such as an amine-based antiaging agent, a quinoline-based antiaging agent, a hydroquinone-based antiaging agent, a phenol-based antiaging agent, a phosphorus-based antiaging agent, or a phosphorous acid ester-based antiaging agent), an antioxidant, an ultraviolet absorber (such as a salicylic acid derivative, a benzophenone-based ultraviolet absorber, a benzotriazole-based ultraviolet absorber, or a hindered amine-based ultraviolet absorber), a lubricant, a plasticizer, and a coloring agent (such as a pigment or a dye). Also an electromagnetic conducting or absorbing material may be blended in the base material as described before.

For the purpose of improving adhesion to the pressure-sensitive adhesive or adhesive layer or the like, one or both surfaces of the electromagnetic conducting or absorbing base material may be subjected to an appropriate surface treatment for example a physical treatment such as a corona treatment or a plasma treatment or a chemical treatment such as an undercoating treatment.

The thickness of the electromagnetic conducting or absorbing base material is not particularly limited. For example, it may be selected within a range of from about 10 $\mu$m to 20 mm, and preferably from about 30 $\mu$m to 12 mm.

Release liner

Examples of the release liner as a support (such as a release liner for pressure-sensitive adhesive tape or sheet) include a base material having a release treated layer formed by a release agent on at least one surface, and a known base material having a low adhesivity. As the release liner, a release liner formed by a base material for release liner and having a release treated layer on at least one surface thereof is suitable. Examples of the base material for release liner include a plastic base material film (synthetic resin film) of every kind, paper, and a multilayered member (two- or three-layered composite member) formed by laminating or co-extruding these base materials. For example, the release treated layer can be formed by using a known release treating agent such as a silicone-based release treating agent, a fluorine-based release treating agent, or a long-chain alkyl-based release treating agent, either singly or in a combination of two or more kinds. The release treated layer can be formed by coating a release treating agent on a prescribed surface (at least one surface) of a base material for release liner, followed by a heating step for drying or a curing reaction.

The thickness of the release liner, the thickness of the base material for release liner, and the thickness of the release treated layer are not particularly limited and can be properly selected depending for example upon the shape of the electromagnetic conducting or absorbing fiber convex structure section.

Coating layer

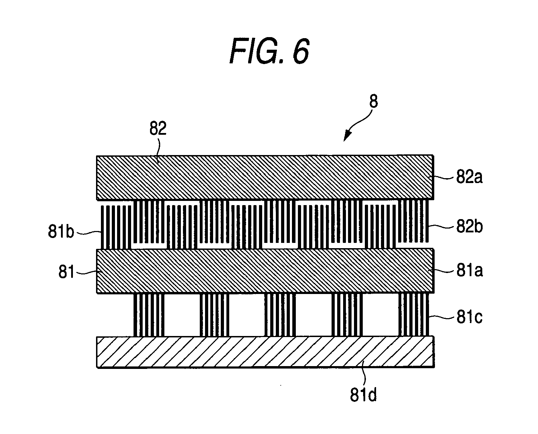

In the structure of the invention, it is important that, among the surface on the side having the electromagnetic conducting or absorbing fiber convex structure section, at least a part of such surface is superposed, in an opposed state, with the surface on which the electromagnetic conducting or absorbing fiber convex structure section is formed. More specifically, the structure may have such a construction (i) that, among the surface on which the electromagnetic conducting or absorbing fiber convex structure section is formed, all such surface is superposed, in an opposed state, with the surface on which the electromagnetic conducting or absorbing fiber convex structure section is formed, or (ii) that, among the surface on which the electromagnetic conducting or absorbing fiber convex structure section is formed, a part of such surface is superposed, in an opposed state, with the surface on which the electromagnetic conducting or absorbing fiber convex structure section is formed while a remaining part of the surface is not superposed, in an opposed state, with the surface on which the electromagnetic conducting or absorbing fiber convex structure section is formed. In the case that the structure has a construction that, among the surface on which the electromagnetic conducting or absorbing fiber convex structure section is formed, a part of such surface is not superposed, in an opposed state, with the surface on which the electromagnetic conducting or absorbing fiber convex structure section is formed, the electromagnetic conducting or absorbing fiber convex structure section, present on the surface which is not superposed in an opposed state with the surface on which the electromagnetic conducting or absorbing fiber convex structure section is formed, is preferably coated by a coating layer, in order to suppress or prevent the fiber from coming off from the base member (namely coming-off of fiber). Thus the structure of the invention may have, as illustrated in Fig. 6, a construction that the surfaces on each of which the electromagnetic conducting or absorbing fiber convex structure sections is formed are superposed with each other in an opposed state, and a construction that a coating layer for covering the electromagnetic conducting or absorbing fiber convex structure section is formed.

Fig. 6 is a schematic partial cross-sectional view illustrating another example of the structure-constituting member in the present invention. In Fig. 6, illustrated are a structure 8, a structure-constituting member 81, a substrate 81a, an electromagnetic conducting or absorbing fiber convex structure section 81b, an electromagnetic conducting or absorbing fiber convex structure section 81c, a coating layer 81d, a structure-constituting member 82, a substrate 82a and an electromagnetic conducting or absorbing fiber convex structure section 82b. In Fig. 6, the structure-constituting member 81 has a construction having the electromagnetic conducting or absorbing fiber convex structure section 81b and the electromagnetic conducting or absorbing fiber convex structure section 81c respectively partially on the respective surfaces of the substrate 81a, and the structure-constituting member 82 has a construction having the electromagnetic conducting or absorbing fiber convex structure section 82b partially on one surface of the substrate 82a. The structure 8 illustrated in Fig. 6 has a construction that the structure-constituting member 81 and the structure-constituting member 82 are superposed in such a form that the surface of the structure-constituting member 81 on which the electromagnetic conducting or absorbing fiber convex structure section 81b is formed and the surface of the structure-constituting member 82 on which the electromagnetic conducting or absorbing fiber convex structure section 82b is formed are opposed with each other, and a construction that the electromagnetic conducting or absorbing fiber convex structure section 81c in the structure-constituting member 81 is covered by the coating layer 81d.

The coating layer is a layer which covers the electromagnetic conducting or absorbing fiber convex structure section, and it can suppress or prevent the fiber constituting the electromagnetic conducting or absorbing fiber convex structure section from coming out from the substrate, and it can effectively enhance retention of the fiber of the electromagnetic conducting or absorbing fiber convex structure section. Also, the coating layer can improve characteristics such as an impact resistance. Such coating layer may be a layer which covers at least a part or an upper surface of the fiber in the electromagnetic conducting or absorbing fiber convex structure section, preferably a layer covering the upper surface of the fiber in the electromagnetic conducting or absorbing fiber convex structure section. The coating layer may be formed in such a form in contact with the electromagnetic conducting or absorbing fiber convex structure section, or in a form not in contact with the electromagnetic conducting or absorbing fiber convex structure section, with another layer or member inbetween.

The coating material constituting the coating layer is not particularly limited and examples thereof include a coating material composition containing, as a principal component, a known polymer component (for example a resin component such as a thermoplastic resin, a thermosetting resin, or an ultraviolet ray-curable resin, a rubber component, or an elastomer component). Concretely, in the coating material composition constituting the coating layer, the polymer component can be properly selected and used among polymer components same as the polymer components as enumerated previously for the substrate (for example a resin component such as a thermoplastic resin, a thermosetting resin, or an ultraviolet ray-curable resin, a rubber component, and an elastomer component).

The coating layer may have a single-layered form or a laminated formed.

In the invention, it is preferable that the coating layer has electromagnetic conducting or absorbing properties. When also the coating layer has the electromagnetic conducting or absorbing properties, it is possible to further enhance the electromagnetic conducting or absorbing properties of the structure. The coating layer having the electromagnetic conducting or absorbing properties can be formed by a coating material composition containing an electromagnetic conducting or absorbing material. The electromagnetic conducting or absorbing material which is used in the coating material is not particularly limited. For example, an electromagnetic conducting or absorbing material such as a metal material, an electromagnetic conducting or absorbing plastic material (for example, an electrically conductive plastic material), and a magnetic material can be used singly or in a combination of two or more kinds. Incidentally, examples of the metal material, the electromagnetic conducting or absorbing plastic material, and the magnetic material include a metal material, an electromagnetic conducting or absorbing plastic material, and a magnetic material as enumerated previously (for example, a metal material, an electromagnetic conducting or absorbing plastic material, and a magnetic material as enumerated previously in the electromagnetic conducting or absorbing fiber which constructs the electromagnetic conducting or absorbing fiber convex structure section, the pressure-sensitive adhesive composition or adhesive composition which constructs the pressure-sensitive adhesive or adhesive layer, and the composition which constructs the substrate).

The coating material composition containing an electromagnetic conducting or absorbing material can be prepared by mixing a coating material and an electromagnetic conducting or absorbing material. Incidentally, in the coating material composition, the content proportion of the electromagnetic conducting or absorbing material is not particularly limited but can be properly selected depending upon the type of a polymer component of the coating material, and the electromagnetic conducting or absorbing properties of the coating layer. For example, the content proportion of the electromagnetic conducting or absorbing material is preferably from 3 to 98% by weight (in particular, from 5 to 95% by weight) with respect to the total solids in the coating material composition. An excessively low content proportion of the electromagnetic conducting or absorbing material reduces the electromagnetic conducting or absorbing properties of the coating layer, while an excessively high content proportion renders the formation of the coating layer difficult.

Since the coating layer is a layer for covering the electromagnetic conducting or absorbing fiber convex structure section, it is important that, in forming the coating layer, the electromagnetic conducting or absorbing fiber convex structure section is formed in advance on the substrate. Accordingly, the coating layer can be formed, after forming the electromagnetic conducting or absorbing fiber convex structure section on the substrate.

As a method for forming the coating layer, a known forming method (for example, a coating method, a dip method, or a spray method) can be employed. The forming method can be properly selected depending upon the form of the coating layer, the type and form of the electromagnetic conducting or absorbing fiber convex structure section. More specifically, the coating layer can be formed by coating the coating material composition on the electromagnetic conducting or absorbing fiber convex structure section formed in the substrate in a form that at least a part of the fiber is positioned outward from the surface of the substrate.

The thickness of the coating layer is not particularly limited and can be properly selected depending upon the type and form of the coating layer and the length of the fiber exposed in the electromagnetic conducting or absorbing fiber convex structure section. The thickness of the coating layer can be, for example, selected within a range of from 10 to 5,000 $\mu$m (preferably from 30 to 3,000 $\mu$m, and more preferably from 30 to 2,000 $\mu$m).

In the invention, the coating layer may also be a layer formed by a pressure-sensitive adhesive tape or sheet. More specifically, the coating layer may be formed by adhering a pressure-sensitive adhesive tape or sheet on the electromagnetic conducting or absorbing fiber convex structure section. The pressure-sensitive adhesive tape or sheet for forming the coating layer may be a pressure-sensitive adhesive tape or sheet of a construction formed solely of a pressure-sensitive adhesive layer (pressure-sensitive adhesive tape or sheet or base material-less type) or a pressure-sensitive adhesive tape or sheet of a construction having a pressure-sensitive adhesive on one or both surfaces of a base material (pressure-sensitive adhesive tape or sheet of base material-containing type). In this manner, the coating layer may be a layer formed by a pressure-sensitive adhesive layer only, or a layer formed by a laminated member of a pressure-sensitive adhesive layer and a base material. The coating layer formed by the pressure-sensitive adhesive tape or sheet can be formed, not by coating of a coating material composition, but by an application of a pressure-sensitive adhesive tape or sheet onto the electromagnetic conducting or absorbing fiber convex structure section.

In the case that the coating layer is formed by a pressure-sensitive adhesive tape or sheet of base material-less type or a pressure-sensitive adhesive tape or sheet of base material-containing type, the pressure-sensitive adhesive layer in each pressure-sensitive adhesive tape or sheet may be either a pressure-sensitive adhesive layer without the electromagnetic conducting or absorbing properties (non-electromagnetic conducting or absorbing pressure-sensitive adhesive layer) or a pressure-sensitive adhesive layer with the electromagnetic conducting or absorbing properties (electromagnetic conducting or absorbing pressure-sensitive adhesive layer). In such coating layer, examples of the pressure-sensitive adhesive composition for constructing the non-electromagnetic conducting or absorbing pressure-sensitive adhesive layer in the pressure-sensitive adhesive tape or sheet include those enumerated for the pressure-sensitive adhesive or adhesive layer as the substrate above. On the other hand, examples of the pressure-sensitive adhesive composition for constructing the electromagnetic conducting or absorbing pressure-sensitive adhesive layer in the pressure-sensitive adhesive tape or sheet include the pressure-sensitive adhesive composition containing the electromagnetic conducting or absorbing material, as enumerated as the pressure-sensitive adhesive composition for constructing the pressure-sensitive adhesive or adhesive layer having the electromagnetic conducting or absorbing properties, in the pressure-sensitive adhesive or adhesive layer as the substrate.

In the case that the coating layer is formed by a pressure-sensitive adhesive tape or sheet of base material-containing type, the base material of the pressure-sensitive adhesive tape or sheet may be either a base material with the electromagnetic conducting or absorbing properties (non-electromagnetic conducting or absorbing base material) or a base material with the electromagnetic conducting or absorbing properties (electromagnetic conducting or absorbing base material). In such coating layer, examples of the non-electromagnetic conducting or absorbing base material in the pressure-sensitive adhesive tape or sheet of base material-containing type include a plastic-based base material having electromagnetic conducting or absorbing properties, a paper-based base material having electromagnetic conducting or absorbing properties and a fibrous base material having electromagnetic conducting or absorbing properties, and specific examples thereof include a plastic-based base material, a paper-based base material and a fibrous base material, as enumerated for the base material as the support in the structure. On the other hand, examples of the electromagnetic conducting or absorbing base material in the pressure-sensitive adhesive tape or sheet of base material-containing type include those as enumerated for the base material as the support in the structure (such as a base material constituted of an electromagnetic conducting or absorbing material or a base material containing an electromagnetic conducting or absorbing material on the surface or in the interior).

Specifically, as the pressure-sensitive adhesive tape or sheet for forming the coating layer, employable for example is a pressure-sensitive adhesive tape or sheet without a base material, a pressure-sensitive adhesive tape or sheet utilizing a plastic film or sheet (such as a polyester film or sheet) as the base material, a pressure-sensitive adhesive tape or sheet utilizing a non-woven cloth as the base material, or a pressure-sensitive adhesive tape or sheet utilizing a metal foil (such as an aluminum foil) as the base material. In such pressure-sensitive adhesive tape or sheet, the pressure-sensitive adhesive for constituting the pressure-sensitive adhesive layer can advantageously be an acrylic pressure-sensitive adhesive or a rubber-type pressure-sensitive adhesive, and may contain an electromagnetic conducting or absorbing material.

A forming method for the pressure-sensitive adhesive tape or sheet for forming the coating layer may be suitably selected from publicly known methods for forming the pressure-sensitive adhesive tape or sheet. As the thickness of the pressure-sensitive adhesive tape or sheet naturally becomes the thickness of the coating layer, it is important to regulate the thicknesses of the pressure-sensitive adhesive layer and the base material in the pressure-sensitive adhesive tape or sheet, so as to attain the thickness of the coating layer, described above. Also in the pressure-sensitive adhesive tape or sheet for constructing the coating layer, each of the pressure-sensitive adhesive layer and the base material may have a single-layered structure or a laminated structure. In the case that the coating layer is constituted of a pressure-sensitive adhesive tape or sheet having pressure-sensitive adhesive layers on both surfaces of the base material, such pressure-sensitive adhesive layers formed on both surfaces of the base material may be same or different with each other.

In the present invention, the coating layer may include an insulating layer (an electrically non-conductive member such as an electrically non-conductive pressure-sensitive adhesive or adhesive layer constituting a pressure-sensitive adhesive surface or an adhesive surface), or may be formed as an insulating layer. Even when the coating layer includes an insulating layer or is constructed as an insulating layer, the structure of the invention is capable of suppressing or preventing a loss in the electromagnetic conducting or absorbing properties, and is capable of effectively exhibiting the electromagnetic conducting or absorbing properties (particularly an electromagnetic shielding property by conducting or absorbing electromagnetic waves).

Structure

The structure of the invention importantly has, as described before, such a construction that an electromagnetic conducting or absorbing fiber convex structure section is formed in at least a part of a substrate in such a form that at least a part of a fiber thereof is positioned outward from the surface of the substrate, and that the surfaces on each of which the fiber convex structure sections is formed are superposed with each other in an opposed state, and, within such construction, appropriate layers may be provided in appropriate positions so far as the effect and function of the invention are not affected significantly. Specific examples of the construction of the structure of the invention include following constructions (A) to (D):

(A) A construction that utilizes one or plural structure-constituting members in each of which a pressure-sensitive adhesive layer or an adhesive layer (pressure-sensitive adhesive or adhesive layer) is formed as a substrate on at least a surface (on one surface or both surfaces) of a base material as a support for supporting the substrate, and, on the pressure-sensitive adhesive or adhesive layer on at least a surface (on one surface or both surfaces) of the base material, an electromagnetic conducting or absorbing fiber convex structure section is formed in such a form that at least a part of a fiber thereof is positioned outward from the surface of the substrate, wherein the one or plural structure-constituting members are folded and/or laminated whereby the surfaces on each of which the electromagnetic conducting or absorbing fiber convex structure sections is formed are superposed with each other in an opposed state;

(B) A construction that utilizes one or plural structure-constituting members in each of which a pressure-sensitive adhesive layer is formed as a substrate on a releasing surface of a release liner for supporting the substrate, and, on the pressure-sensitive adhesive layer on a surface of the release liner, an electromagnetic conducting or absorbing fiber convex structure section is formed in such a form that at least a part of a fiber thereof is positioned outward from the surface of the pressure-sensitive adhesive or adhesive layer, wherein the one or plural structure-constituting members are folded and/or laminated whereby the surfaces on each of which the electromagnetic conducting or absorbing fiber convex structure sections is formed are superposed with each other in an opposed state;

(C) A construction that utilizes one or plural structure-constituting members in each of which a substrate is not supported by a support, and, on at least a surface (one surface or both surfaces) of a polymer layer as the substrate, an electromagnetic conducting or absorbing fiber convex structure section is formed in such a form that at least a part of a fiber thereof is positioned outward from the surface of the polymer layer, wherein the one or plural structure-constituting members are folded and/or laminated whereby the surfaces on each of which the electromagnetic conducting or absorbing fiber convex structure sections is formed are superposed with each other in an opposed state;

(D) In the foregoing constructions (A) to (C), when a structure-constituting member has a construction that a part of the surface on which the electromagnetic conducting or absorbing fiber convex structure section is formed is not superposed in an opposed state with another surface on which the electromagnetic conducting or absorbing fiber convex structure section is formed, a construction that the electromagnetic conducting or absorbing fiber convex structure section on the surface, which is not superposed in an opposed state with the surface on which the electromagnetic conducting or absorbing fiber convex structure section is formed, is covered by a coating layer [stated differently, a construction that utilizes one or plural structure-constituting members in each of which a substrate is supported when necessary by a support (such as a base material or a release liner), and, on at least a surface (one surface or both surfaces) of a pressure-sensitive adhesive or adhesive layer or a polymer layer as the substrate, an electromagnetic conducting or absorbing fiber convex structure section is formed in such a form that at least a part of a fiber thereof is positioned outward from the surface of the pressure-sensitive adhesive or adhesive layer or the polymer layer,

wherein the one or plural structure-constituting members are folded and/or laminated whereby, among the surfaces on each of which the electromagnetic conducting or absorbing fiber convex structure sections is formed, parts of the surfaces are superposed with each other in an opposed state, while the electromagnetic conducting or absorbing fiber convex structure section on the surface not superposed in opposed state with the surface on which the electromagnetic conducting or absorbing fiber convex structure section is formed is covered by a coating layer].

As the structure, also usable is a structure of a construction in which at least two structures, selected from the foregoing constructions (A) to (D), are superposed in plural stages.

In the case that the structure-constituting member has a construction having the electromagnetic conducting or absorbing fiber convex structure sections on both surfaces of the substrate, the electromagnetic conducting or absorbing fiber convex structure sections formed on both surfaces of the substrate may be same electromagnetic conducting or absorbing fiber convex structure sections each other or different electromagnetic conducting or absorbing fiber convex structure sections from each other. Also in the case that the structure-constituting member has a construction having the pressure-sensitive adhesive or adhesive layers on both surfaces of the substrate, the pressure-sensitive adhesive or adhesive layers formed on both surfaces of the substrate may be same pressure-sensitive adhesive or adhesive layers each other or different pressure-sensitive adhesive or adhesive layers from each other.

Furthermore, the surface of the structure may be formed as a pressure-sensitive adhesive surface or an adhesive surface either entirely or partially (for example at least in either one end portion). In the case that the surface of the structure is formed as a pressure-sensitive adhesive surface or an adhesive surface, such pressure-sensitive adhesive surface or adhesive surface may be either of a pressure-sensitive adhesive surface or an adhesive surface formed by a pressure-sensitive adhesive layer or an adhesive layer having the electromagnetic conducting or absorbing properties and a pressure-sensitive adhesive surface or an adhesive surface formed by a pressure-sensitive adhesive layer or an adhesive layer not having the electromagnetic conducting or absorbing properties, but is preferably a pressure-sensitive adhesive surface or an adhesive surface formed by a pressure-sensitive adhesive layer or an adhesive layer having the electromagnetic conducting or absorbing properties. Also in the case that the structure has a construction in which the electromagnetic conducting or absorbing fiber convex structure section is covered by a coating layer, the surface of the coating layer may be formed as a pressure-sensitive adhesive surface or an adhesive surface either entirely or partially (for example at least in either one end portion). In the case that the structure is provided with a coating layer of which surface is formed as a pressure-sensitive adhesive surface or an adhesive surface, such pressure-sensitive adhesive surface or adhesive surface may be either of a pressure-sensitive adhesive surface or an adhesive surface formed by a pressure-sensitive adhesive layer or an adhesive layer having the electromagnetic conducting or absorbing properties and a pressure-sensitive adhesive surface or an adhesive surface formed by a pressure-sensitive adhesive layer or an adhesive layer not having the electromagnetic conducting or absorbing properties. Such pressure-sensitive adhesive surface or adhesive surface can be formed, for example, by a method of utilizing a known pressure-sensitive adhesive or a know adhesive, or by a method of utilizing a known double-sided pressure-sensitive adhesive tape. Therefore, the structure having a pressure-sensitive adhesive surface or an adhesive surface on a surface thereof can be prepared, for example, by a method of employing a support (base material) of which an externally exposed surface is formed in advance as a pressure-sensitive adhesive surface or an adhesive surface, a method of coating a pressure-sensitive adhesive or an adhesive on a surface of a support (base material) of which an externally exposed surface is not formed as a pressure-sensitive adhesive surface or an adhesive surface, a method of applying a double-sided pressure-sensitive adhesive tape or sheet (a double-sided pressure-sensitive adhesive tape or sheet of base material-less type or a double-sided pressure-sensitive adhesive tape or sheet of base material-including type) on a surface of a support (base material) of which an externally exposed surface is not formed as a pressure-sensitive adhesive surface or an adhesive surface, a method of employing a pressure-sensitive adhesive tape or sheet of which an externally exposed surface is formed in advance as a pressure-sensitive adhesive surface or an adhesive surface, a method of coating a pressure-sensitive adhesive or an adhesive on a surface of a coating layer of which an externally exposed surface is not formed as a pressure-sensitive adhesive surface or an adhesive surface, or a method of applying a double-sided pressure-sensitive adhesive tape or sheet (a double-sided pressure-sensitive adhesive tape or sheet of base material-less type or a double-sided pressure-sensitive adhesive tape or sheet of base material-including type) on a surface of a coating layer of which an externally exposed surface is not formed as a pressure-sensitive adhesive surface or an adhesive surface.

According to the present invention, even in the case that the electromagnetic conducting or absorbing fiber convex structure section is covered by a coating layer and the coating layer contains or is formed as an insulating layer (for example an electrically non-conductive member such as an electrically non-conductive pressure-sensitive adhesive or adhesive layer constituting the pressure-sensitive adhesive or adhesive surface), a loss in the electromagnetic conducting or absorbing properties can be suppressed or prevented, and the electromagnetic conducting or absorbing properties (in particular electromagnetic shielding property for shielding electromagnetic waves by conduction or absorption) can be effectively retained and exhibited. In the present invention, when the structure includes a coating layer, the surface thereof is preferably formed as an insulating layer. Such insulating layer can be formed, for example, by a method of employing a pressure-sensitive adhesive tape or sheet of base material-containing type utilizing a non-electromagnetic conducting or absorbing properties (particularly a plastic base material not having the electromagnetic conducting or absorbing properties), or a method of applying a pressure-sensitive adhesive tape or sheet of base material-containing type utilizing a non-electromagnetic conducting or absorbing properties (particularly a plastic base material not having the electromagnetic conducting or absorbing properties) onto the surface of the coating layer.

The structure of the invention is not particularly limited with respect to the form so far as it has the foregoing constructions. Concretely, the structure may have a form of every kind such as spherical, cylindrical, polygonal, polygonal conical, conical, tabular, and sheet-like forms. Of these, a sheet-like form is preferable. That is, it is preferable that the structure of the invention is a sheet-like structure having a sheet-like form. Incidentally, the sheet-like structure can have not only electromagnetic conducting or absorbing properties but also pressure-sensitive adhesive or adhesive properties (in particular, pressure-sensitive adhesive property). For example, in the case where the sheet-like structure has pressure-sensitive adhesive property, the sheet-like structure may have a form of a pressure-sensitive adhesive tape or sheet in which, at a side thereof not bearing the electromagnetic conducting or absorbing fiber convex structure section, the surface of the pressure-sensitive adhesive layer is formed as a pressure-sensitive adhesive surface (for example a form of a pressure-sensitive adhesive tape or sheet employing at least a structure-constituting member which bears the electromagnetic conducting or absorbing fiber convex structure section on one surface and has a pressure-sensitive adhesive surface on the other surface, wherein the pressure-sensitive adhesive surface in such structure-constituting member serves as the pressure-sensitive adhesive surface of the sheet-like structure).

Incidentally, in the case where the structure is a sheet-like structure, the sheet-like structure can be prepared in form wound into a roll or in a single-layered or stacked form. As the structure can be so constructed as to have an excellent property for preventing the tumbling of the fiber of the electromagnetic conducting or absorbing fiber convex structure section even when wound into a roll or laminated into a stack of sheets, there can be obtained a sheet-like structure capable of suppressing or preventing the tumbling of the fiber in the electromagnetic conducting or absorbing fiber convex structure section even when unwound from a roll or separated from the stack. Therefore, the structure of the invention, in the case of a sheet-like structure, can be made into a product as the structure of a form wound into a roll or of a form of a single sheet or a stack of sheets.

As the structure of the invention has such a construction in which the electromagnetic conducting or absorbing fiber convex structure section is formed in the substrate in a form that at least a part of a fiber thereof is positioned outward from the surface of the substrate, and in which the surfaces on each of which the fiber convex structure sections is formed are superposed with each other in an opposed state, thus being capable of suppressing or preventing the coming-out of the fiber from the electromagnetic conducting or absorbing fiber convex structure section and capable of effectively exhibiting the electromagnetic conducting or absorbing properties by the electromagnetic conducting or absorbing fiber convex structure section, it can be used in a variety of applications utilizing electromagnetic conducting or absorbing properties by the electromagnetic conducting or absorbing fiber convex structure section. For example it can be advantageously utilized in applications utilizing for example an electric conductivity of conducting or passing an electric current, a property of conducting electromagnetic waves (electromagnetic conducting property), an electromagnetic shielding property of shielding electromagnetic waves by conduction or by absorption, or an electrostatic removing property of removing an electrostatic charge by a conduction. Specifically, the structure of the invention can be advantageously utilized as an electric conductive material capable of conducting or passing electricity, an electromagnetic wave conductive material capable of conducting electromagnetic waves, an electromagnetic absorbing material capable of absorbing electromagnetic waves, an electromagnetic shielding material capable of shielding electromagnetic waves, or an electrostatic removing material capable of removing a static thereby preventing static generation (or an electrostatic hindrance preventing material capable of preventing various hindrances by static), and can be utilized particularly advantageously as an electric conductive material, an electromagnetic absorbing material or an electromagnetic shielding material.

Specifically, the structure of the invention, when employed as an electromagnetic shielding material, can be utilized as an electromagnetic shielding material for a wire covering (particularly electromagnetic shielding material for automotive wires), an electromagnetic shielding material for electronic components, an electromagnetic shielding material for clothing and an electromagnetic shielding material for buildings. The structure of the invention, when employed as an electromagnetic shielding material for a wire covering, can be used for shielding the electromagnetic waves generated from the wire, thereby suppressing or preventing noises from the wire. The structure of the invention, when employed as an electromagnetic shielding material for an electronic component, can be used for shielding the electromagnetic waves from the exterior to the electronic component (for example an electronic circuit board or an electronic equipment equipped with an electronic circuit board), thereby suppressing or preventing noises to the electronic component. Also the structure of the invention, when employed as an electromagnetic shielding material for a clothing, can be used for shielding the electromagnetic waves generated from a computer, those from electric cooling equipment, and those from medical equipment (such as so-called "MRI" equipment, so-called "CT-scanner" equipment or so-called "X-ray imaging" equipment), thereby suppressing or preventing electromagnetic influences to the human body. Furthermore, the structure of the invention, when employed as an electromagnetic shielding material for a building, can be used for shielding the electromagnetic waves generated from the interior of the building, thereby suppressing or preventing information leak, and for shielding the electromagnetic waves from the exterior to the building, thereby inhibiting use of so-called "mobile phone" or preventing detrimental influence by FM waves (radio waves) (for example preventing erroneous function of wireless microphone) in buildings used for various purposes (such as a movie theater, a concert hall, a drama theater, a museum, an art museum, a wedding hall, or a meeting or lecture hall) or a room (for example meeting room) in the building.

Further, the structure of the invention, when employed as an electromagnetic absorbing material, can be used as an electromagnetic absorbing material for a building. Specifically, in the case that the structure of the invention is used as an electromagnetic absorbing material for a building, it may be adhered to a partitioning member of a room (for example a member constituting a ceiling surface, a wall surface or a floor surface) for the purpose of suppressing or preventing a scattering or a random reflection of electromagnetic waves emitted from an electronic equipment installed inside the room, thereby avoiding an erroneous operation or ensuring an efficient function of the various electronic equipment installed inside the room.

In the structure of the invention, on the surfaces that are opposed or not opposed, the electromagnetic conducting or absorbing fiber convex structure sections may be electromagnetic conducting or absorbing fiber convex structure sections formed by electromagnetic conducting or absorbing fibers of totally same kinds, or by electromagnetic conducting or absorbing fibers of partially or totally different kinds. Particularly in the structure of the invention, as the combination of the electromagnetic conducting or absorbing fiber convex structure sections respectively formed on the surfaces superposed in the opposed state with each other, a combination of electromagnetic conducting or absorbing fiber convex structure sections formed by respectively different electromagnetic conducting or absorbing fibers may be employed whereby it becomes possible to effectively exhibit a shielding function against not only electromagnetic waves having a single peak wavelength but also electromagnetic waves having plural peak wavelengths. Thus, by selecting the combination of the electromagnetic conducting or absorbing fiber convex structure sections respectively formed on the surfaces superposed in the opposed state suitably according to the type of electromagnetic wave to be shielded, it is possible not only to improve the prevention of coming-out of the fiber of the electromagnetic conducting or absorbing fiber convex structure section but also to effectively shield electromagnetic waves by a single structure (electromagnetic shielding material) against a radiation source such as a material and a substance, from which plural electromagnetic waves having various peak lengths are emitted in a prescribed proportion.

Specifically, the structure having such construction can be, for example in a construction of employing two structure-constituting members each having the electromagnetic conducting or absorbing fiber convex structure section on one surface only of a substrate, a structure which utilizes a structure-constituting member bearing, on a surface thereof, an electromagnetic conducting or absorbing fiber convex structure section, formed by an electromagnetic conducting or absorbing fiber capable of exhibiting an electromagnetic shielding property corresponding to a specified peak wavelength of the electromagnetic waves to be shielded, and a structure-constituting member bearing, on a surface thereof, an electromagnetic conducting or absorbing fiber convex structure section, formed by an electromagnetic conducting or absorbing fiber capable of exhibiting an electromagnetic shielding property corresponding to another specified peak wavelength of the electromagnetic waves to be shielded, and in which these two structure-constituting members are laminated with each other in an opposed state.

Also in the structure of the invention, as the electromagnetic conducting or absorbing fiber constituting each electromagnetic conducting or absorbing fiber convex structure section in each structure-constituting member, there may be employed plural (two or more) electromagnetic conducting or absorbing fibers (for example plural (two or more) electromagnetic conducting or absorbing material fibers or plural (two or more) electromagnetic conducting or absorbing property-imparted fibers such as electromagnetic conducting or absorbing material-coated fibers or electromagnetic conducting or absorbing material-impregnated fibers utilizing different metal materials as the electromagnetic conducting or absorbing materials), or by employing even a single electromagnetic conducting or absorbing fiber utilizing plural (two or more) electromagnetic conducting or absorbing materials (for example an electromagnetic conducting or absorbing property-imparted fiber such as an electromagnetic conducting or absorbing material-coated fiber or an electromagnetic conducting or absorbing material-impregnated fiber utilizing plural (two or more) electromagnetic conducting or absorbing materials), whereby it becomes possible to effectively exhibit a shielding function against not only electromagnetic waves having a single peak wavelength but also electromagnetic waves having plural peak wavelengths. Thus, as the electromagnetic conducting or absorbing fiber constituting the electromagnetic conducting or absorbing fiber convex structure section, by combining plural electromagnetic conducting or absorbing fibers and by suitably regulating the proportion thereof, it is possible not only to improve the prevention of coming-out of the fiber of the electromagnetic conducting or absorbing fiber convex structure section but also to effectively shield electromagnetic waves by a single structure (electromagnetic shielding material) against a radiation source such as a material and a substance, from which plural electromagnetic waves having various peak lengths are emitted in a prescribed proportion.

Thus, the structure of the invention, when employed as an electromagnetic shielding material, can be easily prepared in a construction capable of exhibiting a shielding function not restricted by the type of radiation source emitting electromagnetic waves and effective against radiation sources of a wide range. Therefore the present invention enables to easily obtain an electromagnetic shielding material capable of a shielding by more effectively conducting or absorbing the electromagnetic waves.

Incidentally, in the case where an electromagnetic conducting or absorbing properties-imparted fiber is used as the electromagnetic conducting or absorbing fiber, within metal materials as the electromagnetic conducting or absorbing material for constructing the electromagnetic conducting or absorbing properties-imparted fiber, for example, nickel and gold are different in the type or wavelength of electromagnetic waves to be shielded by conduction or absorption. Accordingly, for example, when a nickel plated fiber and a gold plated fiber are used as the electromagnetic conducting or absorbing fibers respectively for forming the electromagnetic conducting or absorbing fiber convex structure sections on the surfaces superposed in the opposed state with each other or when a nickel plated fiber and a gold plated fiber are used for forming an electromagnetic conducting or absorbing fiber convex structure section, the resulting electromagnetic shielding material can efficiently exhibit an electromagnetic shielding effect by nickel and an electromagnetic shielding effect by gold, respectively, thereby enabling one to effectively shield electromagnetic waves.

In the structure of the invention, the electromagnetic conducting or absorbing fiber convex structure is formed in such a form that at least a part of the fiber is positioned outward from the surface of the substrate, so that, in the use as an electromagnetic shielding material or the like, the structure of the invention can be constructed usable in a form that regardless of the surface shape of a body to be shielded against electromagnetic waves, at least a part of the fiber of the electromagnetic conducting or absorbing fiber convex structure section is brought into contact with the surface of such various bodies, and the electromagnetic shielding properties and the like can be exhibited more effectively.

In addition, in the structure of the invention, by properly adjusting the length of the electromagnetic conducting or absorbing fiber, the density of the electromagnetic conducting or absorbing fiber in the electromagnetic conducting or absorbing fiber convex structure section, as well as the type of the electromagnetic conducting or absorbing fiber for forming the electromagnetic conducting or absorbing fiber convex structure section, the structure of the invention can be made to serve as a structure capable of exhibiting the desired or adequate electrical conductivity and electromagnetic shielding properties.

Incidentally, for the purpose of further conducting or absorbing electromagnetic waves, the structure of the invention may be grounded.

Furthermore, the structure of the invention can be used in various applications utilizing various characteristics such as soundproofing, thermal conductivity, light reflection properties, and design properties as well as various applications utilizing electromagnetic conducting or absorbing properties.

The structure of the invention is not particularly restricted in the producing method therefor, and can be produced, for example by a method of preparing single or plural structure-constituting members by forming an electromagnetic conducting or absorbing fiber convex structure section on a prescribed surface of a substrate, and folding or laminating the single or plural structure-constituting members in such a form that the surfaces on each of which the electromagnetic conducting or absorbing fiber convex structure sections is formed are opposed with each other. Also in case of forming the electromagnetic conducting or absorbing fiber convex structure section partially on the prescribed surface of the substrate, employable advantageously is a method of positioning a member having a hole section on the substrate in such a position corresponding to a prescribed position for forming the electromagnetic conducting or absorbing fiber convex structure section, and then forming the electromagnetic conducting or absorbing fiber convex structure section on a portion of the surface of the substrate corresponding to the hole section of the member having a hole section.

In the structure-constituting member, a producing method for an electromagnetic conducting or absorbing fiber convex structure section is not particularly restricted, but is preferably a flocking process. Therefore, in the producing method for the structure of the invention, the process for producing the structure-constituting member preferably includes a step for forming an electromagnetic conducting or absorbing fiber convex structure section on a prescribed surface in a substrate by utilizing a flocking process. Accordingly, in the invention, it is possible to produce a structure having electromagnetic conducting or absorbing properties easily and inexpensively by a simple method of flocking an electromagnetic conducting or absorbing fiber.

More specifically, by subjecting a prescribed surface of the substrate to a flocking by applying the flocking process, a structure-constituting member having the electromagnetic conducting or absorbing fiber convex structure section on the substrate can be produced by forming the electromagnetic conducting or absorbing fiber convex structure section in a form that at least a part of the fiber is positioned outward from the surface of the substrate on a prescribed surface of the substrate. As such flocking process, an electrostatic flocking process is especially suitable. As the electrostatic flocking process, there can be utilized a process in which a material to be flocked having a pressure-sensitive adhesive or a substrate is set as a counter electrode to one electrode; a direct current high voltage is applied thereto; flocks (fibers) are supplied between these electrodes; and the flocks are made to fly along the line of electric force due to a Coulomb force and made to stick to the surface of the material to be flocked (for example, a surface of the substrate or a wall surface of a concave of the substrate), thereby achieving flocking. Such electrostatic flocking process is not particularly limited so far as it is a known electrostatic flocking process. For example, any of an up method, a down method and a side method as described in "Principle and Truth of Electrostatic Flocking" in SENI (Fiber), Vol. 34, No. 6 (1982-6) may be employed.

Incidentally, in the structure-constituting member, in forming the electromagnetic conducting or absorbing fiber convex structure section in a prescribed partial site of the substrate (for example, a prescribed partial site on the surface of the substrate or a wall surface of a concave formed partially on the substrate) by the flocking process (in particular, the electrostatic flocking process), it is preferred, for efficient production of the structure-constituting member, to position a member having a hole section (penetrating hole section) (such as a releasable base material having a hole section) on the surface of the substrate. Therefore, the producing method for producing the structure-constituting member, in producing the structure of the invention, is preferably a method of positioning a member having a hole section (particularly a releasable base material having a hole section) on the surface of the substrate, and then forming a electromagnetic conducting or absorbing fiber convex structure section in a form that at least a part of the fiber is positioned outward from the surface of the substrate in a site of the substrate corresponding to the hole section of the member.

Then, after single or plural structure-constituting members are produced in this manner, the member having the hole section is peeled off and the single or plural structure-constituting member are folded and/or laminated in such a form that the surfaces on each of which the electromagnetic conducting or absorbing fiber convex structure sections is formed are superposed with each other in an opposed state. In this manner, the structure having the electromagnetic conducting or absorbing fiber convex structure section in a form capable of suppressing or preventing coming-out of the fiber can be produced efficiently.

As such member having hole section, there can be suitably selected, according to the type of the substrate, a member that can be peeled off after the formation of the electromagnetic conducting or absorbing fiber convex structure section on the substrate. More specifically, in the case that the substrate is a pressure-sensitive adhesive or adhesive layer, as the member having the hole section, a base material having a hole section and showing a releasing property to the pressure-sensitive adhesive or adhesive layer (release base material having hole section) can be employed advantageously. Examples of such release base material having hole section include a release liner having a hole section, obtained by perforating a release liner (separator) as enumerated for the aforementioned release liner as the support. Also in the case that the substrate is a polymer layer, there may be employed any member having a hole section. In the case that the substrate is a polymer layer, it is important, in subjecting the substrate to an electrostatic flocking process in order to form the electromagnetic conducting or absorbing fiber convex structure section, to use the member having the hole section in such a form that the member having the hole section can be fixed to the surface of the polymer layer and, after the formation of the electromagnetic conducting or absorbing fiber convex structure section by electrostatic flocking on the substrate, the member having the hole section can be peeled off from the polymer layer. Therefore, in the case that the substrate is a polymer layer, the member having the hole section can for example be a member having a hole section provided with pressure-sensitive adhesive layer having a releasable property. It is important that such member having the hole section is peeled off after the formation of the electromagnetic conducting or absorbing fiber convex structure section.

In the method of producing a structure-constituting member by forming the electromagnetic conducting or absorbing fiber convex structure section in a prescribed portion of the substrate by means of the member having a hole section, it is possible to control a position for forming the electromagnetic conducting or absorbing fiber convex structure section on the substrate surface, a size and a number of the electromagnetic conducting or absorbing fiber convex structure section and a concave for forming the electromagnetic conducting or absorbing fiber convex structure section by a position of the hole section (penetrating hole section) in the member having the hole section and a by a size and a number of the hole section in the member having the hole section.

In the invention, the electromagnetic conducting or absorbing properties (in particular, the electrical conductivity) of the structure can be evaluated by measuring a volume specific resistance according to JIS K6705. The electromagnetic conducting or absorbing properties of the structure can be controlled depending upon the size of the respective electromagnetic conducting or absorbing fiber convex structure section which is formed on the substrate in the structure-constituting member (the occupied area of one electromagnetic conducting or absorbing fiber convex structure section) and the shape thereof, the proportion of the whole electromagnetic conducting or absorbing fiber convex structure section formed on the substrate with respect to the entire surface of the substrate (the proportion of the occupied area of the whole electromagnetic conducting or absorbing fiber convex structure section), the shape (length and thickness) and raw material of the fiber in the electromagnetic conducting or absorbing fiber convex structure section.

Examples

The invention will be described below in detail with reference to the following Examples, but it should not be construed that the invention is limited to these Examples. Incidentally, in the Examples and Comparative Examples, electrostatic flocking process was carried out by using a box provided with a line capable of spraying fibers in a positively charged state and of flowing a continuous strip-shaped sheet in a negatively charged state from one side to the other side (size: 2.5 m (length in flow direction of line) x 1.3 m (width) x 1.4 m (height)). Specifically, the electrostatic flocking process was carried out by spraying the fibers from an upper portion (one position) within the aforementioned box under an applied voltage of 30 kV and introducing and moving the continuous web-shaped sheet within the box at a line speed of 5 m/min, with flocking on the upper surface.

Example 1

On one surface of an aluminum base material (thickness: 50 $\mu$m) as an electromagnetic conducting or absorbing base material, an acrylic pressure-sensitive adhesive (base polymer: butyl acrylate-acrylic acid copolymer) containing 35% by weight (proportion based on the whole amount of solids) of a nickel powder blended therein was coated in a thickness after drying of 35 $\mu$m to form an electromagnetic conducting or absorbing pressure-sensitive adhesive layer. Thereafter, an electrostatic flocking process was conducted, utilizing, as an electromagnetic conducting or absorbing fiber, an acrylic fiber whose surface had been subjected to a nickel plating treatment (a plating treatment with nickel) (fiber diameter: 20 $\mu$m, fiber length: 0.5 mm), on the entire surface of the electromagnetic conducting or absorbing pressure-sensitive adhesive layer, thereby flocking the acrylic fiber surfacially subjected to a nickel plating treatment on the entire surface of the electromagnetic conducting or absorbing pressure-sensitive adhesive layer. Thus prepared were two sheet-shaped structure-constituting members (also called "sheet-like structure-constituting member A1") in a form that a fiber napped section (electromagnetic conducting or absorbing fiber napped section) formed by the electromagnetic conducting or absorbing fiber (acrylic fiber whose surface had been subjected to a nickel plating treatment) was formed on the entire surface of the electromagnetic conducting or absorbing pressure-sensitive adhesive layer formed on the electromagnetic conducting or absorbing base material.

Then the two sheet-like structure-constituting members A1 were superposed in such a form that the surfaces each having the electromagnetic conducting or absorbing fiber napped sections formed thereon was formed were opposed with each other, thereby obtaining a sheet-like structure (also called "sheet-like structure A1") having a construction in which the surfaces each having the electromagnetic conducting or absorbing fiber napped sections formed thereon were opposed with each other.

Example 2

At first, as a release base material having a hole section, "Nisseki Conwood XN9567 (trade name)" (manufactured by Nisseki Plasto Co., pore size: 1 x 1 mm, weight: 151 g/m$^2$, pore rate: 46%, thickness: 0.34 mm) was prepared.
Then, on one surface of an aluminum base material (thickness: 50 $\mu$m) as an electromagnetic conducting or absorbing base material, an acrylic pressure-sensitive adhesive (base polymer: butyl acrylate-acrylic acid copolymer) containing 35% by weight (proportion based on the whole amount of solids) of a nickel powder blended therein was coated in a thickness after drying of 35 $\mu$m to form an electromagnetic conducting or absorbing pressure-sensitive adhesive layer. Then, after the aforementioned release base material having the hole section was adhered on the surface of the electromagnetic conducting or absorbing pressure-sensitive adhesive layer, an electrostatic flocking process was conducted, utilizing, as an electromagnetic conducting or absorbing fiber, an acrylic fiber whose surface had been subjected to a nickel plating treatment (a plating treatment with nickel) (fiber diameter: 20 $\mu$m, fiber length: 0.5 mm), thereby flocking the acrylic fiber whose surface had been subjected to a nickel plating treatment in a site corresponding to the hole section (penetrating hole section) of the release base material having the hole section, on the surface of the electromagnetic conducting or absorbing pressure-sensitive adhesive layer. Thus prepared were two sheet-shaped structure-constituting members (also called "sheet-like structure-constituting member A2") in a form that a fiber napped section (electromagnetic conducting or absorbing fiber napped section) formed by the electromagnetic conducting or absorbing fiber (acrylic fiber whose surface had been subjected to a nickel plating treatment) was formed partially on the surface of the electromagnetic conducting or absorbing pressure-sensitive adhesive layer formed on the electromagnetic conducting or absorbing base material.
Then the two sheet-like structure-constituting members A2 were superposed in such a form that the surfaces each having the electromagnetic conducting or absorbing fiber napped sections formed thereon were opposed with each other, thereby obtaining a sheet-like structure (also called "sheet-like structure A2") having a construction in which the surfaces each having the electromagnetic conducting or absorbing fiber napped sections formed thereon were opposed with each other.

Example 3

The same procedures as in Example 2 were followed, except for using, as a release base material having a hole section, "Nisseki Conwood XN6065 (trade name)" (manufactured by Nisseki Plasto Co., pore size: 1 x 1 mm, weight: 100 g/m$^2$, pore rate: 38%, thickness: 0.48 mm), thereby preparing two sheet-shaped structure-constituting members (also called "sheet-like structure-constituting member A3") in a form that a fiber napped section (electromagnetic conducting or absorbing fiber napped section) formed by the electromagnetic conducting or absorbing fiber (acrylic fiber whose surface had been subjected to a nickel plating treatment) was formed partially on the surface of the electromagnetic conducting or absorbing pressure-sensitive adhesive layer formed on the electromagnetic conducting or absorbing base material, and the same procedure as in Example 2 was followed except for employing the sheet-like structure-constituting members A3 thereby obtaining a sheet-like structure (also called "sheet-like structure A3") having a construction in which the surfaces each having the electromagnetic conducting or absorbing fiber napped sections formed thereon were opposed with each other.

Example 4

At first a release base material having a hole section was prepared by forming, in a polyethylene-based resin base material (thickness 0.10 mm), circular hole sections (diameter 0.8 mm) by perforations with a substantially uniform pitch so as to obtain a pore rate of 2%. Then the same procedures as in Example 2 were followed, except for using such release base material having the hole section, thereby preparing two sheet-shaped structure-constituting members (also called "sheet-like structure-constituting member A4") in a form that a fiber napped section (electromagnetic conducting or absorbing fiber napped section) formed by the electromagnetic conducting or absorbing fiber (acrylic fiber whose surface had been subjected to a nickel plating treatment) was formed partially on the surface of the electromagnetic conducting or absorbing pressure-sensitive adhesive layer formed on the electromagnetic conducting or absorbing base material, and the same procedure as in Example 2 was followed except for employing the sheet-like structure-constituting members A4 thereby obtaining a sheet-like structure (also called "sheet-like structure A4") having a construction in which the surfaces each having the electromagnetic conducting or absorbing fiber napped sections formed thereon were opposed with each other.

Comparative Example 1

On one surface of an aluminum base material (thickness: 50 $\mu$m) as an electromagnetic conducting or absorbing base material, an acrylic pressure-sensitive adhesive (base polymer: butyl acrylate-acrylic acid copolymer) containing 35% by weight (proportion based on the whole amount of solids) of a nickel powder blended therein was coated in a thickness after drying of 35 $\mu$m to form an electromagnetic conducting or absorbing pressure-sensitive adhesive layer. Thereafter, an electrostatic flocking process was conducted, utilizing, as an electromagnetic conducting or absorbing fiber, an acrylic fiber whose surface had been subjected to a nickel plating treatment (a plating treatment with nickel) (fiber diameter: 20 $\mu$m, fiber length: 0.5 mm), on the entire surface of the electromagnetic conducting or absorbing pressure-sensitive adhesive layer, thereby flocking the acrylic fiber surfacially subjected to a nickel plating treatment on the entire surface of the electromagnetic conducting or absorbing pressure-sensitive adhesive layer. Thus prepared were two sheet-shaped structure-constituting members (also called "sheet-like structure B1") in a form that a fiber napped section (electromagnetic conducting or absorbing fiber napped section) formed by the electromagnetic conducting or absorbing fiber (acrylic fiber whose surface had been subjected to a nickel plating treatment) was formed on the entire surface of the electromagnetic conducting or absorbing pressure-sensitive adhesive layer formed on the electromagnetic conducting or absorbing base material. Thus the sheet-like structure B1 corresponds to the sheet-like structure-constituting member A 1 in Example 1.

Evaluation of magnetic shielding effect

On the sheet-like structures A 1 to A4 obtained in Examples 1 to 4 and the sheet-like structure B1 obtained in Comparative Example 1, a magnetic shielding effect was evaluated by an electromagnetic shielding evaluation system by the KEC method. The evaluation results are shown in Table 1.

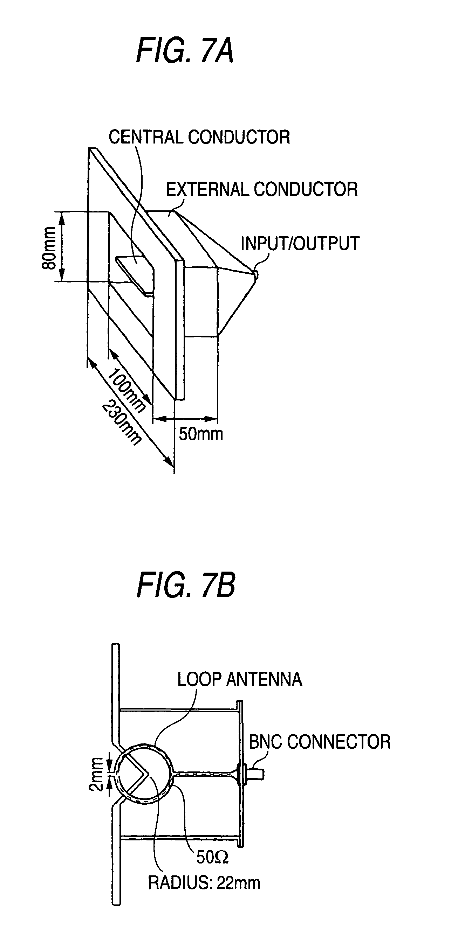

Incidentally, the KEC method in the electromagnetic shielding evaluation system by the KEC method is a method developed by Kansai Electronic Industry Development Center. According to this method, the shielding effect in a near electromagnetic field is evaluated by using an amplifier, a spectrum analyzer and respective shielding boxes (an electrical field shielding box and a magnetic field shielding box) marketed from Anritsu Corp. Concretely, by using an electrical field shielding box as shown in Fig. 7A or a magnetic field shielding box as shown in Fig. 7B, the sheet-like structure is placed in a prescribed position; an electromagnetic wave having a prescribed frequency (MHz) (incident wave: incident electrical field or incident magnetic field) is made incident with a prescribed energy (hereinafter also represented as "E 1") from the side of the electromagnetic conducting or absorbing fiber convex structure section of the sheet-like structure; an energy (hereinafter also represented as "E2") of a transmitted wave (transmitted electrical field or transmitted magnetic field) which has transmitted into the other surface of the sheet-like structure is measured; and the shielding effect (dB) is determined according to the following formula (1).

$$\text{Shielding effect (dB)} = 20 \times \log (E2/E1) \qquad (1)$$

Figs. 7A and 7B each is an outline view illustrating a shielding box to be used in the electromagnetic shielding evaluation system by the KEC method; and Fig. 7A shows an electrical field shielding box, while Fig. 7B shows a magnetic field shielding box. The electrical field shielding box (unit for electrical field shielding evaluation) has a structure in which dimensional distribution of a TEM cell is employed and the inside of the plane vertical to the transmission axis direction is bisected symmetrically in the lateral direction. However, a shortcircuit formation is prevented by the insertion of a measurement sample. Also the magnetic field shielding box (unit for magnetic field shielding evaluation) has a structure in which a shielded circular loop antenna is used for generating an electromagnetic field of a large magnetic field component and is combined with a metal plate having a 90° angle in such a form that a 1/4 portion of the loop antenna is exposed externally.

Incidentally, the shielding effect is described in detail in Denjiha Shahei Gijutsu (Electromagnetic Shielding Technologies) (pages 253 to 269) in Tokkyo Mappu Shirizu: Denki 23 (Patent Map Series: Electricity 23) published by Japan Institute of Invention and Innovation, etc. In this reference, it is described that the shielding effect is an index to what extent the electromagnetic energy of the incident electrical field or incident magnetic field can be attenuated, and the shield effect is expressed as a value of 20 times of a common logarithm of a ratio of the electromagnetic energy of the transmitted electrical field or transmitted magnetic field to the electromagnetic energy of the incident electrical field or incident magnetic field (unit: dB). Also, with respect to the shielding effect, it is described (on pages 253 to 254) that as criteria of the shield effect, the shielding effect is scarce at from 0 to 10 dB; the shielding effect is minimum at from 10 to 30 dB; the shielding effect is at an average level at from 30 to 60 dB; the shielding effect is considerably revealed at from 60 to 90 dB; and the shielding effect is highest at 90 dB or more.

In the foregoing KEC method, a measurement limit is different in the low frequency region and in the high frequency region. This is because a transmission characteristic of shielding (aluminum shielding plate) is constant regardless of the frequency (-105 dBm from 1 MHz to 1 GHz in the electrical field shielding box), while a through-transmission characteristic has a frequency characteristic (reception level being attenuated by about -50 dBm in the low frequency side, whereas reception level at the high frequency side being substantially same as in the transmitting side with attenuation of 0 dBm). Incidentally, it is thought that the transmission characteristic of shield (2 mm-thick aluminum shielding plate) is actually a much smaller value and that -105 dBm is a noise level (ability) of the spectrum analyzer. Also it is thought that if the noise level (ability) of the spectrum analyzer becomes higher, the transmission characteristic of shielding (aluminum shielding plate) becomes further smaller, and a difference from the through-transmission is made larger, whereby the measurement limit can be expanded. However, when expressed in terms of electrical power, -105 dBm is in fact a very small value as not more than 0.1 pW, it is considered that a further improvement will be difficult.

Table 1

| | Frequency (MHz) | | | | | | | | | | | | | | | |
|---|---|---|---|---|---|---|---|---|---|---|---|---|---|---|---|---|
| | 1 | 2 | 3 | 5 | 7 | 10 | 20 | 30 | 50 | 70 | 100 | 200 | 300 | 500 | 700 | 1000 |
| Measurement limit | 57 | 63 | 66 | 71 | 74 | 77 | 83 | 86 | 90 | 92 | 95 | 98 | 100 | 97 | 93 | 75 |
| Example 1 | 45 | 57 | 64 | 72 | 74 | 77 | 83 | 86 | 90 | 92 | 95 | 98 | 100 | 97 | 93 | 75 |
| Example 2 | 50 | 61 | 66 | 70 | 74 | 77 | 83 | 86 | 90 | 92 | 95 | 98 | 100 | 97 | 93 | 75 |
| Example 3 | 52 | 62 | 66 | 70 | 74 | 77 | 83 | 86 | 90 | 92 | 95 | 98 | 100 | 97 | 93 | 75 |
| Example 4 | 29 | 40 | 58 | 70 | 74 | 73 | 75 | 76 | 80 | 82 | 84 | 87 | 88 | 90 | 90 | 77 |
| Comp.Ex.1 | 29 | 36 | 39 | 44 | 48 | 52 | 63 | 69 | 80 | 88 | 95 | 98 | 100 | 97 | 93 | 75 |

As will be apparent from Table 1, it was confirmed that the sheet-like structures A1 to A4 of Examples 1 to 4 were excellent in the magnetic field shielding effect. Particularly the sheet-like structures A1 to A3 of Examples 1 to 3 were significantly excellent in the magnetic field shielding effect. Besides, the sheet-like structures A1 to A3 of Examples 1 to 3 were significantly excellent in the magnetic field shielding effect in a low frequency region (particularly from 1 to 10 MHz).

It is naturally evident also that the sheet-like structures A1 to A4 of Examples 1 to 4 were excellent also in the electric field shielding effect.

Evaluation of fiber coming-out preventing property

Each of the sheet-like structures A1 to A4 obtained in Examples 1 to 4 and the sheet-like structure B1 obtained in Comparative Example 1 was cut into an A5-size. Also an A5-sized polyethylene terephthalate film (thickness: 38 $\mu$m) was prepared. The polyethylene terephthalate film was superposed on each surface of each sheet-like structure (sheet-like structures A1 to A4 and sheet-like structure B1) to sandwich the sheet-like structure between the polyethylene terephthalate films, and the assembly was placed in a polyethylene bag and was let to stand for 10 minutes without a load and at the room temperature. After the standing, each polyethylene terephthalate film was peeled off from the sheet-like structure and the surface of the polyethylene terephthalate film was visually observed to evaluate the fiber coming-out preventing property according to following criteria. Results of evaluation are shown in Table 2.

Evaluation criteria:

(+): no or scarce deposition of fibers on the surfaces of both polyethylene terephthalate films
(-): fibers deposited on the surface of at least either polyethylene terephthalate film

Table 2

|  | Example 1 | Example 2 | Example 3 | Example 4 | Comp. Ex. 1 |
|---|---|---|---|---|---|
| Fiber coming-out preventing property | (+) | (+) | (+) | (+) | (-) |

Based on Table 2, in the sheet-like structures A1 to A4 obtained in Examples 1 to 4, fibers were not or scarcely deposited on the both polyethylene terephthalate films superposed on the surfaces, and it was confirmed that the coming-out of the fiber was suppressed or prevented. On the other hand, in the sheet-like structure B 1 obtained in Comparative Example 1, fibers were considerably deposited on the polyethylene terephthalate film superposed with the surface bearing the electromagnetic conducting or absorbing fiber convex structure section, thus confirming that the fibers showed coming-out.

Therefore, it was confirmed that the sheet-like structures of Examples was capable, despite of the presence of the electromagnetic conducting or absorbing fiber convex structure section, of effectively holding the fiber on the substrate thereby suppressing or preventing the coming-out of the fiber, and still capable of exhibiting the electromagnetic conducting or absorbing properties at an excellent level.

While the invention has been described in detail and with reference to specific embodiments thereof, it will be apparent to one skilled in the art that various changes and modifications can be made therein without departing from the scope thereof.

This application is based on Japanese patent application No. 2006-123368 filed April 27, 2006, the entire contents thereof being hereby incorporated by reference.

Further, all references cited herein are incorporated in their entireties.

**Claims**

1. A structure having a characteristic of conducting or absorbing electromagnetic waves, which comprises:

a substrate; and
a fiber convex structure section having a characteristic of conducting or absorbing electromagnetic waves, which is formed at least partially on the substrate in such a form that at least a part of a fiber thereof is positioned outward from the surface of the substrate,

wherein the surfaces on each of which the fiber convex structure sections having a characteristic of conducting or absorbing electromagnetic waves is formed are superposed with each other in an opposed state.

2. The structure according to claim 1, which comprises one or a plurality of members each having a substrate and a fiber convex structure section which has a characteristic of conducting or absorbing electromagnetic waves and is formed at least partially on the substrate in such a form that at least a part of a fiber thereof is positioned outward from the surface of the substrate,
wherein said one or plurality of members are folded and/or laminated so that the surfaces on each of which the fiber convex structure sections having a characteristic of conducting or absorbing electromagnetic waves is formed are superposed with each other in an opposed state.

3. The structure according to claim 2, wherein, on each of the surfaces opposed with each other when said one or plurality of members are superposed, the fiber convex structure section having a characteristic of conducting or absorbing electromagnetic waves is partially formed in such a form that a portion of one surface on which the fiber convex structure section having a characteristic of conducting or absorbing electromagnetic waves is formed is capable of being superposed in an opposed state with a portion of another surface on which the fiber convex structure section having a characteristic of conducting or absorbing electromagnetic waves is not formed.

4. The structure according to claim 3, wherein the fiber convex structure section having a characteristic of conducting or absorbing electromagnetic waves is formed partially on the substrate, by superposing a member having a hole section on the surface of the substrate, forming the fiber convex structure section having a characteristic of conducting or absorbing electromagnetic waves on a portion of the surface of the substrate corresponding to the hole section of the member having a hole section, and then peeling off the member having a hole section.

5. The structure according to claim 2, wherein, on each of the surfaces opposed with each other when said one or plurality of members are superposed, the fiber convex structure section having a characteristic of conducting or absorbing electromagnetic waves is entirely formed in such a form that a fiber of the fiber convex structure section having a characteristic of conducting or absorbing electromagnetic waves on one surface is positioned between fibers of the fiber convex structure section having a characteristic of conducting or absorbing electromagnetic waves on another surface so that the surfaces are capable of being superposed with each other.

6. The structure according to claim 1, wherein the substrate is at least one member selected from the group consisting of a pressure-sensitive adhesive layer, an adhesive layer and a polymer layer.

7. The structure according to claim 1, wherein the substrate has a characteristic of conducting or absorbing electromagnetic waves.

8. The structure according to claim 1, wherein the substrate is formed on at least one surface of a support.

9. The structure according to claim 8, wherein the support has a characteristic of conducting or absorbing electromagnetic waves.

10. The structure according to claim 1, which is a sheet-like structure having a sheet-like form.

11. The structure according to claim 1, which is used as an electrically conductive material.

12. The structure according to claim 1, which is used as an electromagnetic wave absorbing material.

13. The structure according to claim 1, which is used as an electromagnetic wave shielding material.

## FIG. 1A

## FIG. 1B

## FIG. 2

## FIG. 3A

## FIG. 3B

## FIG. 4

## FIG. 5A

## FIG. 5B

## FIG. 5C

# FIG. 6

## FIG. 7A

CENTRAL CONDUCTOR

EXTERNAL CONDUCTOR

INPUT/OUTPUT

80mm

100mm

230mm

50mm

## FIG. 7B

LOOP ANTENNA

BNC CONNECTOR

2mm

50Ω

RADIUS: 22mm

**European Patent Office**

**EUROPEAN SEARCH REPORT**

Application Number

EP 07 00 8575

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | JP 2005 209687 A (NISSHINBOU ENGINEERING KK) 4 August 2005 (2005-08-04) * abstract * * figure 1 * * paragraph [0001] * * claims 1-3 * ----- | 1-3,5-13 | INV. H05K9/00 H01Q17/00 |
| Y | DE 37 10 322 A1 (HIRAOKA & CO LTD [JP]) 15 October 1987 (1987-10-15) * abstract * * columns 4-20 * ----- | 1-3,5-13 | |
| Y | WO 2006/022463 A (JOINSET CO LTD [KR]; KIM SUN-KI [KR]) 2 March 2006 (2006-03-02) * abstract * * figure 2 * * page 1, line 1 - page 3, line 24 * ----- | 11-13 | |
| D,A | JP 61 002394 A (ASAHI CHEMICAL IND) 8 January 1986 (1986-01-08) * abstract * * figure 1 * ----- | 1-13 | TECHNICAL FIELDS SEARCHED (IPC) |
| P,X | EP 1 653 791 A (NITTO DENKO CORP [JP]) 3 May 2006 (2006-05-03) * abstract * * figure 1B * ----- | 1,2,6,10 | H01Q H05K |

The present search report has been drawn up for all claims

| Place of search | Date of completion of the search | Examiner |
|---|---|---|
| The Hague | 27 August 2007 | Hüschelrath, Jens |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

**EP 1 850 650 A1**

## ANNEX TO THE EUROPEAN SEARCH REPORT
## ON EUROPEAN PATENT APPLICATION NO.                    EP 07 00 8575

This annex lists the patent family members relating to the patent documents cited in the above-mentioned European search report.
The members are as contained in the European Patent Office EDP file on
The European Patent Office is in no way liable for these particulars which are merely given for the purpose of information.

27-08-2007

| Patent document cited in search report | | Publication date | Patent family member(s) | | Publication date |
|---|---|---|---|---|---|
| JP 2005209687 | A | 04-08-2005 | NONE | | |
| DE 3710322 | A1 | 15-10-1987 | AU | 587318 B2 | 10-08-1989 |
| | | | AU | 7073187 A | 05-11-1987 |
| | | | CA | 1328581 C | 19-04-1994 |
| | | | FR | 2602716 A1 | 19-02-1988 |
| | | | GB | 2189740 A | 04-11-1987 |
| | | | US | 4749625 A | 07-06-1988 |
| WO 2006022463 | A | 02-03-2006 | NONE | | |
| JP 61002394 | A | 08-01-1986 | NONE | | |
| EP 1653791 | A | 03-05-2006 | CN | 1767758 A | 03-05-2006 |
| | | | JP | 2006128373 A | 18-05-2006 |
| | | | KR | 20060052274 A | 19-05-2006 |
| | | | US | 2006093782 A1 | 04-05-2006 |

EPO FORM P0459

For more details about this annex : see Official Journal of the European Patent Office, No. 12/82

43

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002501821 T
- JP 10120904 A

- JP 61002394 A
- JP 2006123368 A

**Non-patent literature cited in the description**

- Principle and Truth of Electrostatic Flocking. *SENI (Fiber,* June 1982, vol. 34 (6

- Denjiha Shahei Gijutsu (Electromagnetic Shielding Technologies. Tokkyo Mappu Shirizu: Denki 23 (Patent Map Series: Electricity 23. Japan Institute of Invention and Innovation, 253-269